# EUROPEAN PATENT SPECIFICATION

(11) **EP 4 459 621 B1**
(45) Date of publication and mention of the grant of the patent: **05.11.2025**
(21) Application number: 23188992.4
(22) Date of filing: 01.08.2023
(51) Int. Cl.: G11C 11/54, G06N 3/065, G11C 15/04

(54) **ARCHITECTURE FOR COMPUTATIONAL MEMORY AND MEMORY SYSTEMS**
ARCHITEKTUR FÜR RECHNERSPEICHER UND SPEICHERSYSTEME
ARCHITECTURE POUR SYSTÈMES DE MÉMOIRE ET DE MÉMOIRE COMPUTATIONNELLE

(30) Priority: 05.05.2023 US 202318143777
(43) Date of publication of application: 06.11.2024
(73) Proprietor: MACRONIX INTERNATIONAL CO., LTD., Hsinchu 300094 (TW)
(72) Inventor: TSENG, Po-Hao, Taichung City 411 (TW)
(74) Representative: Krauns, Christian

(56) References cited:
- US-A1- 2020 075 099
- US-A1- 2022 093 184
- US-A1- 2023 073 272

## Description

### BACKGROUND

### Field

This disclosure relates to memory enabled to perform computation, including memory enabling computational solid state drives (SSDs).

### Description of Related Art

Increasing data volume increases processing, storage, and bandwidth requirements to manage, organize, select, and analyze data in real time. Techniques are needed to address these increasing requirements.

In an example conventional system, data is stored on a storage device that is accessible to a processor via a bus. Prior to processing, the data is transferred from the storage device to the processor (and/or memory directly accessible to the processor) via the bus. Then the data is operated on by the processor, and results are optionally provided back to the storage device via the bus. Thus, processor utilization and/or bus bandwidth utilization are increased as data volume increases. In some usage scenarios, throughput is limited by bandwidth and/or latency between the processor and the storage device. Techniques are needed to reduce, e.g., the processor utilization and/or bus bandwidth utilization.

The US 2023/073272 A1 discloses a fuzzy string search circuit. In an approximate-search-circuit, a memory matrix of a conventional storage circuit is caused to function as a data conversion circuit for calculating the inner-product distance between stored data and input data, by inputting the input data to the memory matrix in the form of a time series of pulse-signals, and the location of stored data with the highest inner-product is output from a circuit that calculates the inner-product in real time.

The US 2022/093184 A1 discloses a storage device that performs a read operation by using a time interleaved sampling page buffer. The storage device controls a sensing point in time, when bit lines of even page buffer circuits are sensed, and a sensing point in time, when bit lines of odd page buffer circuits are sensed, with a certain time difference, and performs an Even Odd Sensing operation in a stated order of even sensing and odd sensing. The storage device performs a two-step Even Odd Sensing operation and performs a main sensing operation on a selected memory cell according to a result of the two-step Even Odd Sensing operation.

The US 2020/075099 A1 discloses ternary content addressable memory (TCAM) circuits. The TCAM circuit includes a first spin-orbit torque (SOT) magnetic tunnel junction (MTJ) element having a pinned layer coupled to a first read transistor controlled by a first search line, and having a spin hall effect (SHE) layer coupled in a first configuration across complemented write inputs. The TCAM circuit include a second SOT MTJ element having a pinned layer coupled to a second read transistor controlled by a second search line, and having a SHE layer coupled in a second configuration across the complemented write inputs. The TCAM circuit includes a bias transistor configured to provide a bias voltage to drain terminals of the first read transistor and the second read transistor, and a voltage keeper element that couples the drain terminals to a match indicator line.

### SUMMARY

The invention is defined by the features of independent claims. Preferred embodiments are set out in the dependent claims.

### BRIEF DESCRIPTION OF THE DRAWINGS

Fig. 1 illustrates an example hardware system based on one or more computational solid state drives (SSDs).
Fig. 2 illustrates an example computational memory for performing a coarse search followed by a fine search dependent on results of the coarse search.
Fig. 3 illustrates an example computational memory for performing a coarse search followed by a computation dependent on results of the coarse search.
Fig. 4 illustrates an example computational memory for performing a coarse search followed by an access operation dependent on results of the coarse search.
Fig. 5 illustrates an example flow diagram for a technique to operate a computational memory.
Fig. 6A and Fig. 6B collectively illustrate searching via information provided on word lines.
Fig. 6C and Fig. 6D collectively illustrate searching via information provided on bit lines.
Fig. 7 illustrates an example computational SSD.
Fig. 8 illustrates an example hardware system having a computational SSD.

### DETAILED DESCRIPTION

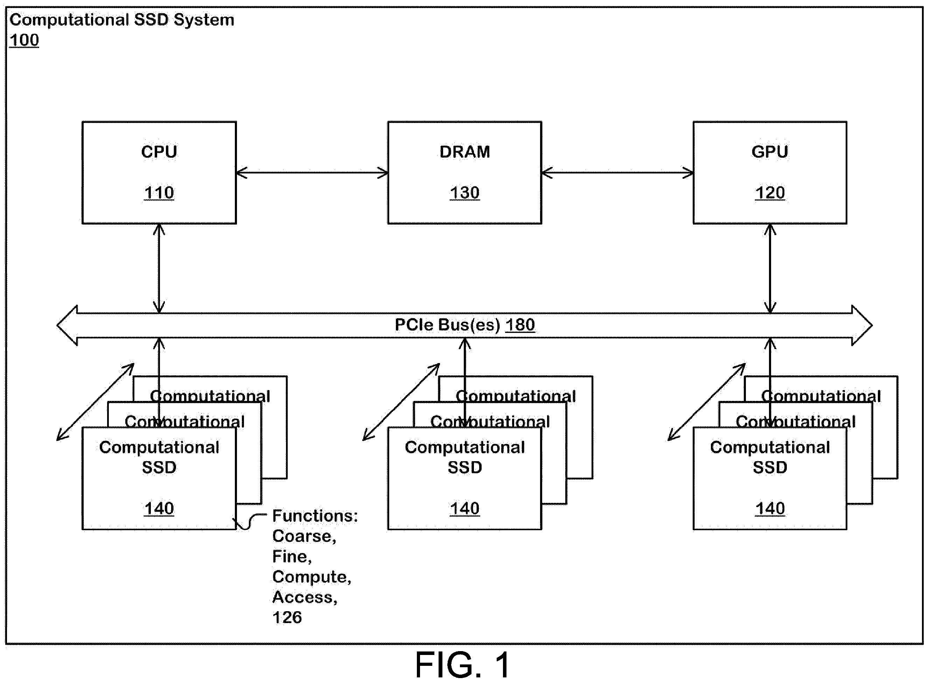

A detailed description of techniques relating to architecture for computational solid state drives (SSDs) is provided with reference to Figs 1-8.

One or more flow diagrams are described herein. Processing described by the flow diagrams is implementable and/or directable using processors programmed using computer programs stored in memory accessible to computer systems and executable by the processors, using dedicated logic hardware (including field programmable integrated circuits), and using various combinations thereof. Various actions are combinable, performable in parallel, and/or performable in a different sequence without affecting processing achieved. In some cases, a rearrangement of actions achieves identical results only if certain other changes are made as well. In other cases, a rearrangement of actions achieves identical results only if certain conditions are satisfied. Furthermore, for clarity, some of the flow diagrams herein omit certain some actions not necessary for understanding the disclosed techniques. Various additional actions are performable before, after, and/or between the illustrated actions.

Examples of selected acronyms, mnemonics, and abbreviations used in the description are as follows.

| Acronym/Mnemonic/Abbreviation | Example |
|---|---|
| 2D | two- dimensional |
| 2T0C | Two-Transistor Zero-Capacitor |
| 3D | three-dimensional |
| AND type array architecture | AND array, e.g., series connections of devices form an array |
| BL | Bit Line |
| CAM | Content Addressable Memory |
| CIM | Computing-In-Memory |
| CPU | Central Processing Unit |
| DRAM | Dynamic Random Access Memory |
| FeFET | Ferroelectric Field-Effect Transistor |
| GPU | Graphics Processing Unit |
| IMC | In-Memory-Computing |
| IMS | In-Memory-Search |
| MAC | Multiplication-ACcumulation |
| MLC | Multi-Level Cell, e.g., a memory cell enabled to store more than one bit of information |
| MSB | Most Significant Bit(s) |
| NAND array | Not AND array, e.g., series connection of devices forming an array |
| NAND type array architecture | Not AND array, e.g., series connections of devices form an array |
| NOR type array architecture | Not OR array, e.g., parallel connections of devices form an array |
| OR type array architecture | OR array, e.g., parallel connections of devices form an array |
| PCIe | Peripheral Component Interconnect express |
| QLC | Quad-Level Cell, e.g., a memory cell enabled to store four bits of information |
| RAM | Randomly Accessible read/write Memory |
| SA | Sense Amplifier (sometimes referred to as "sense amp") |
| SLC | Single-Level Cell, e.g., a memory cell enabled to store one bit of information |
| SONOS | Silicon-Oxide-Nitride-Oxide-Silicon |
| SSD | Solid State Drive |
| TCAM | Ternary CAM |
| TLC | Triple-Level Cell or Tri-Level Cell, e.g., a memory cell enabled to store three bits of information |
| WL | Word Line |

An example key-value store (e.g., a key-value SSD) is an object-based storage that receives an object description (e.g., a key) and in response accesses an object identifiable by the object description (e.g., a value corresponding to the key). In some key-value stores, a translation layer converts between an object description and a corresponding reference to underlying data blocks of non-volatile storage.

### Computational SSD Concepts

A system based on computational SSD technology, as described herein, reduces processor utilization and/or bus bandwidth utilization. The system is enabled to perform computational techniques (e.g., searching, computing, and/or accessing) using resources of the computational SSDs, rather than processor and/or bus resources, thus reducing or minimizing information movement between processing elements and storage devices. Computational SSD technology enables managing, organizing, selecting, and analyzing ever increasing data volume in real time. A computational SSD (sometimes referred to as a "SmartSSD") is enabled to store and to operate on data locally, e.g., using resources of the computational SSD such as to perform CIM, IMC, and/or IMS. Thus, processing, storage, and bandwidth requirements of a system are reduced by using the computational SSD.

Moreover, using computational SSDs enables using CPU and/or GPU resources for other tasks, enabling fast results. In some usage scenarios, using computational SSDs reduces needs for purchasing additional processors and/or servers. In some usage scenarios, using computational SSDs reduces needs for purchasing additional power and/or cooling resources. In some usage scenarios, using computational SSDs enables new insights and opportunities using self-processing technology for accelerating a variety of applications. Example applications that computational SSD technology is applicable to include video processing, database management, and artificial intelligence.

An example computational SSD is enabled to perform a coarse search function followed by a second function that is dependent on the coarse search function. The example computational SSD is based on a single memory array that is usable in two portions: (1) a portion dedicated to the coarse search function and (2) a portion dedicated to the second function. Example second functions include a fine search (e.g., IMS) function, a compute (e.g., IMC) function, and an access (e.g., value for Key/Value pairs) function.

As one specific example, a key-value SSD is implementable using a computational SSD as described herein.

A computational SSD is comprised of one or more computational memories. A computational SSD is enabled to perform a plurality of functions using a same one of the computational memories. For example, a first function is performed on a particular computational memory and then a second function (e.g., based on results of the first function) is performed on the particular computational memory. In some instances, the plurality of functions is performed on a same memory array of a same computational memory.

For a search operation example, the first function comprises a coarse filter and/or search function and the second function comprise a fine filter and/or search function. For a compute operation example, the first function comprises a coarse filter and/or search function and the second function comprises an in-memory computing function. For an access operation example, the first function comprises a coarse filter and/or search function and the second function comprises a data access function.

In some scenarios, a coarse filter and/or search function is usable for reducing or eliminating processing relating to uninteresting or unwanted portions of a database. E.g., responsive to the coarse filter function, a word line determined by the coarse filter and/or search function is activated for use in a subsequent action. In the search, compute, and access operation examples, the subsequent action comprises respectively the fine filter and/or search function, the in-memory computing function, and the data access function.

In some variations, the coarse filter and/or search function uses search information provided on word lines, e.g., akin to a ternary CAM. In some variations, the fine search function uses search information provided on bit lines, e.g., relating to hyper-dimensional searching. In some variations, the compute function uses compute information provided on bit lines. In some variations, the access function is usable to provide a value corresponding to a key of a key-value pair, e.g., for use by a CPU and/or GPU.

### Example Computational SSD System

In some computational SSD systems, one or more computational SSDs are enabled to perform a first function followed by a second function that is dependent on results of the first function. For a first example, the first function is a coarse search function, and the second function is a fine search function. For a second example, the first function is a coarse search function, and the second function is a compute function. For a third example, the first function is a coarse search function, and the second function is an access function.

In some configurable computational SSD systems, one or more computational SSDs are enabled to perform a first function followed by a second configurable function that is dependent on results of the first function. For various examples, the configuration of the second function is at various granularities, e.g., from the entirety of an SSD to a single memory array of a configurable computational SSD. E.g., an SSD is configured as a dedicated search computational SSD, having the entirety of the SSD configured with the first function as a coarse search function and the second function that is a fine search function. E.g., another SSD is configured with a first portion of memory arrays configured for compute functions and a second portion of memory arrays configured for an access function.

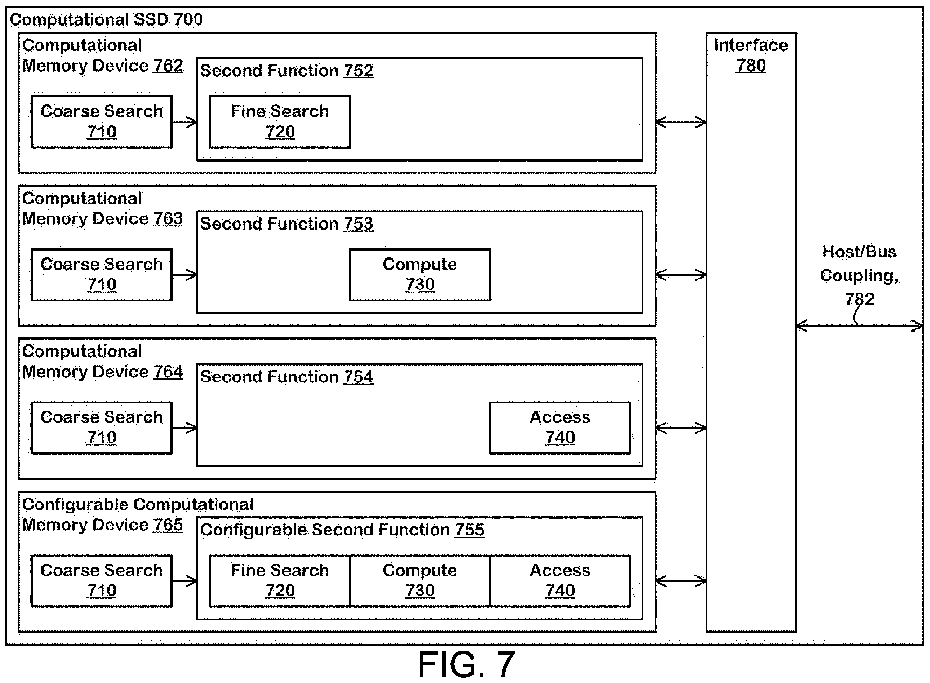

Fig. 1 illustrates an example hardware system based on one or more computational SSDs as Computational SSD System 100. The system comprises hardware blocks CPU 110, GPU 120, DRAM 130, and one or more instances of Computational SSD 140 that are coupled by hardware block PCIe Bus(es) 180. Each instance of Computational SSD 140 comprises one or more computational SSDs such as one or more instances of Computational SSD 700 of Fig. 7. The instances of Computational SSD 140 are enabled to perform functions related to computational SSDs, as depicted by Functions: Coarse, Fine, Compute, Access 126.

CPU 110 comprises one or more processing units, such as any combination of hardware units enabled to execute programmed instructions, microprocessors, signal processors, AI processors, and the like. GPU 120 comprises one or more processing units, such as any combination of units enabled to accelerate processing that is subject to relatively highly parallel processing, such as graphics processing, signal processing, and/or AI processing. DRAM 130 comprises one or more DRAM devices for storage of instructions and/or data in greater quantities than storage internal to CPU 110 and/or GPU 120. PCIe Bus(es) 180 enables communication between the elements coupled to it (e.g., CPU 110, GPU 120, and instances of Computational SSD 140) using one or more PCIe Bus(es) 180. The instances of Computational SSD 140 are variously enabled to perform coarse search, fine search, compute, and access functions on data stored on the respective computational SSD, without transferring the data to CPU 110, DRAM 130, and/or GPU 120.

Computational SSD System 100 enables reduced or minimized data movement between conventional processing elements (e.g., CPU 110 and/or GPU 120) and computational storage elements (e.g., one or more instances of Computational SSD 140). Various computational operations are performed on the computational SSDs, using locally stored data available on the SSDs.

Other partitionings of elements, coupling between elements, and capabilities and/or capacities of elements illustrated in the figure are contemplated, as well as additional elements, according to usage requirements.

### Computational Memory

Three examples of computational memory are described. A first example is two IMS operations in series, e.g., a coarse search followed by a fine search dependent on results of the coarse search. A second example is an IMS operation in series with an IMC operation dependent on results of the coarse search, e.g., a coarse search followed by a computing operation. A third example is an IMS operation in series with an access operation dependent on results of the coarse search, e.g., a coarse search followed by an access operation.

### Computational Memory -- IMS => IMS

Returning to the first example of computational memory (two IMS operations in series), a single computational memory array has two portions (one for each of the IMS operations) that are enabled to respectively perform a coarse search (e.g., operate as a TCAM) followed by a fine search dependent on results of the coarse search. Conceptually, the coarse search portion implements a filter (e.g., via word line inputs) to reduce computation (e.g., hyper-dimension searching via bit line inputs) performed by the fine search portion.

As an example of operation, selected coarse search information (e.g., all or any portions of a key optionally in conjunction with key mask information) is used to generate (coarse search) values for word lines of the single computational memory array ("the array"). Bit lines of the coarse search portion are operated to enable matching the word line values with coarse search information stored in memory devices of the coarse search portion. The memory devices are arranged in series groups of devices referred to as memory strings. Each memory string enables matching the word line values with coarse search information stored in the memory string. The memory string indicates a match, for example, by changing impedance. The change in impedance is then reflected on the bit line the memory string is coupled to by a change in voltage. E.g., the memory string indicates a match by discharging the bit line. Sense amplifiers (sense amps) of the coarse search portion detect the bit line voltage changes (if any) and generate match results in response. Exact matches and/or approximate matches correspond to high similarity between the word line values and the coarse search information stored in memory devices of the coarse search portion. For example, in a one-hot encoding, a match is coded as a "1" and a mismatch is coded as a "0".

Subsequently, the matches are then used to generate (fine search) values for the word lines of the array. In the example one-hot encoding (with a single match), a single one of the word lines is driven to "read" and the remainder of the word lines are driven to "pass", enabling a fine search in accordance with the coarse match result. Concurrently, bit lines of the fine search portion are operated in accordance with matching selected fine search parameters (e.g., all or any portions of one or more hyper-dimension search parameters optionally in conjunction with hyper-dimension mask information) with fine search information stored in memory devices of the fine search portion. Sense amps of the fine search portion detect bit line changes and generate match results that indicate high similarity between the fine search parameters and the fine search information stored in memory devices, and the match results are then combined (e.g., counted) across one or more bit lines to determine one or more overall results. For example, a highest one of the overall results corresponds to a best match.

The coarse search portion accommodates "match 1" and "match 0" match operations and optionally "match anything" (e.g., "don't care" or alternatively "WildCard") and "match nothing" (e.g., "invalid value" or alternatively "invalid search") match operations via pairs of word lines and pairs of series memory devices in the first portion. Similarly, the fine search portion accommodates similar encodings via pairs of bit lines and pairs of corresponding memory devices in the second portion.

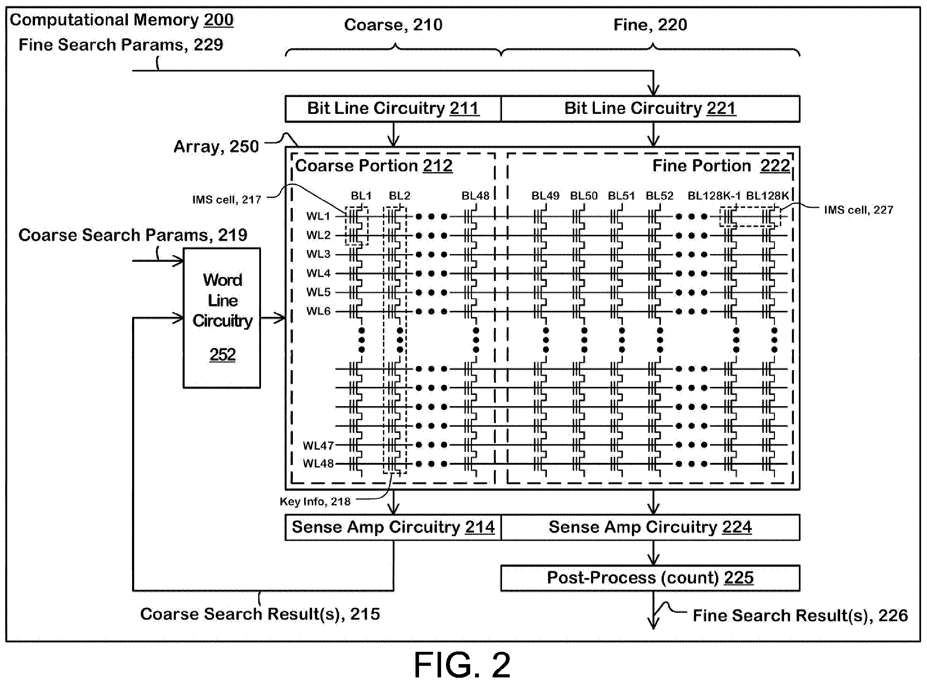

Fig. 2 illustrates an example computational memory for performing a coarse search followed by a fine search dependent on results of the coarse search as Computational Memory 200.

Computational Memory 200 comprises two portions, Coarse 210 for performing the coarse search and Fine 220 for performing the fine search. Coarse Portion 212 and Fine Portion 222 are portions of a same memory array, Array 250. Word Line Circuitry 252 is enabled to provide results of the coarse search to the fine search.

Coarse 210 comprises Bit Line Circuitry 211, Coarse Portion 212, and Sense Amp Circuitry 214. Coarse Portion 212 comprises a plurality of memory strings each comprising a plurality of series-coupled memory devices. The memory strings are coupled to Bit Line Circuitry 211 and Sense Amp Circuitry 214 and thus are conceptually series-coupled in the vertical direction in the figure. The memory strings are replicated conceptually in the horizontal direction in the figure, with word lines coupling corresponding devices of each of the memory strings in the horizontal dimension. For each memory string, one end of the memory string (e.g., a bit line terminal) is coupled to Bit Line Circuitry 211 and the other end of the memory string (e.g., a sense line terminal) is coupled to Sense Amp Circuitry 214.

Bit Line Circuitry 211 comprises bit line circuitry enabled to operate each of the bit line terminals according to a predetermined value, e.g., Bit Line Circuitry 211 comprises a precharger for each of the bit line terminals of Coarse Portion 212. The prechargers operate (in conjunction with other circuitry, e.g., Word Line Circuitry 252 and/or Sense Amp Circuitry 214) to precharge the memory strings of Coarse Portion 212.

Sense Amp Circuitry 214 comprises sense circuitry enabled to determine a current and/or a voltage change of each of the sense amp terminals of Coarse Portion 212 according to one or more predetermined thresholds, e.g., Sense Amp Circuitry 214 comprises a sense amp for each of the sense amp terminals. The sense amps operate (in conjunction with other circuitry, e.g., Word Line Circuitry 252 and/or Bit Line Circuitry 211) to determine current and/or voltage changes of the memory strings of Coarse Portion 212. Sense Amp Circuitry 214 provides results of the changes to Word Line Circuitry 252 via Coarse Search Result(s) 215.

The current and/or the voltage changes of the memory strings of Coarse Portion 212 are due, e.g., to selective discharge of the memory strings based on stored values of the series-coupled memory devices of the memory strings, as well as values provided to the word lines by Word Line Circuitry 252.

Fine 220 comprises Bit Line Circuitry 221, Fine Portion 222, Sense Amp Circuitry 224, and Post-Process (count) 225. Fine Portion 222 (similar to Coarse Portion 212) comprises a plurality of memory strings each comprising a plurality of series-coupled memory devices. The memory strings are coupled to Bit Line Circuitry 221 and Sense Amp Circuitry 224 and thus are conceptually series-coupled in the vertical direction in the figure. The memory strings are replicated conceptually in the horizontal direction in the figure, with word lines coupling corresponding devices of each of the memory strings in the horizontal dimension. For each memory string, one end of the memory string (e.g., a bit line terminal) is coupled to Bit Line Circuitry 221 and the other end of the memory string (e.g., a sense line terminal) is coupled to Sense Amp Circuitry 224.

Bit Line Circuitry 221 (similar in some ways to Bit Line Circuitry 211) comprises bit line circuitry enabled to operate each of the bit line terminals according to a dynamic value provided via Fine Search Params 229 (rather than a predetermined value as in Bit Line Circuitry 211), e.g., Bit Line Circuitry 221 comprises a conditional precharger for each of the bit line terminals of Fine Portion 222. Bit Line Circuitry 221 operates the bit line terminals in pairs, as conceptually indicated by IMS cell (Fine) 227. The conditional prechargers operate (in conjunction with other circuitry, e.g., Word Line Circuitry 252 and/or Sense Amp Circuitry 224) to conditionally precharge the memory strings of Fine Portion 222.

Sense Amp Circuitry 224 comprises sense circuitry enabled to determine a current and/or a voltage change of each of the sense amp terminals of Fine Portion 222 according to one or more predetermined thresholds, e.g., Sense Amp Circuitry 224 comprises a sense amp for each of the sense amp terminals. The sense amps operate (in conjunction with other circuitry, e.g., Word Line Circuitry 252 and/or Bit Line Circuitry 221) to determine current and/or voltage changes of the memory strings of Fine Portion 222. Sense Amp Circuitry 224 provides results of the changes to Post-Process (count) 225, such as a single binary digit for each of the sense amps. Each single binary digit indicates one of two mutually exclusive conditions: (1) the change is less than or equal to the threshold, and (2) the change is greater than the threshold.

The current and/or the voltage changes of the memory strings of Fine Portion 222 are due, e.g., to selective discharge of the conditionally precharged memory strings based on stored values of the series-coupled memory devices of the memory strings, as well as values provided to the word lines by Word Line Circuitry 252.

Post-Process (count) 225 comprises counting circuitry, enabled to count how many of the sense amps of Sense Amp Circuitry 224 indicate the change is greater than the threshold (or alternately less than or equal to the threshold). The count indicates a relative match of Coarse Search Params 219 and/or Fine Search Params 229 compared respectively to various values stored in Coarse Portion 212 and/or Fine Portion 222 as provided (e.g., to a host) via Fine Search Result(s) 226. For another example, outputs of a first portion of the sense amps of Sense Amp Circuitry 224 are counted together as a first result provided via Fine Search Result(s) 226 and outputs of a remainder portion of the sense amps of Sense Amp Circuitry 224 are counted together as a second result provided via Fine Search Result(s) 226. Various arrangements of sense amps and counting are usable to enable comparisons of various portions of Fine Search Params 229, e.g., one or more hyper-dimensions.

Thus, Fine Search Result(s) 226 encompasses information based on Coarse Search Params 219, information stored in Coarse Portion 212, information based on Fine Search Params 229, information stored in Fine Portion 222, and counting as performed by Post-Process (count) 225.

Word Line Circuitry 252 comprises word line conversion and driving circuitry enabled to conditionally operate in two modes, e.g., in a first mode during a first phase of operation and then in a second mode during a second phase of operation. In the first mode, one or more search parameters, Coarse Search Params 219, (e.g., a key and optionally a mask) are converted to voltages suitable to perform a coarse search function using the memory strings of Coarse Portion 212 (e.g., to compare in parallel against respective instances of Key Info 218). In the first mode, Word Line Circuitry 252 converts the voltages in pairs, as conceptually indicated by IMS cell (Coarse) 217. In the second mode, one or more results from operation in the first mode, Coarse Search Result(s) 215, are converted to voltages suitable to perform a fine search function using the memory strings of Fine Portion 222. In some variations, in the second mode, circuitry not used in the second mode is not activated (e.g., bit lines in the coarse search portion are not activated in the second mode).

In some variations and/or usage scenarios, during the first phase of operation, Coarse 210 functions as a TCAM enabled for exact matching and at most one sense amp of Sense Amp Circuitry 214 detects a change corresponding to an exact match. In the second phase of operation (responsive to detection of an exact match), Fine 220 is operated once. Word Line Circuitry 252 drives a single one of the word lines of Array 250 (corresponding to the exact match represented on Coarse Search Result(s) 215) for reading (e.g., provides voltage Vread). Word Line Circuitry 252 activates the remaining word lines of Array 250 for passing (e.g., provides voltage Vpass).

Coarse 210 and/or Fine 220 are independently implementable according to various characteristics. The characteristics include match type (e.g., exact and/or approximate), number of matches (zero, one, and/or a plurality), and sequencing of coarse matches (parallel or sequential). Example match types include exact match and approximate match. An exact match corresponds to all bits matching, such as all bits of search parameters matching all bits of a value stored in a memory string. An approximate match corresponds to less than all bits matching, such as all but one bit matching, all but two bits matching, or alternatively a fraction of the bits matching, such as 90% of the bits matching (e.g., 9 out of 10 bits match). For example, Coarse 210 is enabled to perform an exact match and Fine 220 is enabled to perform an approximate match. For another example, Coarse 210 and Fine 220 are both enabled to perform exact matches (or enabled to perform approximate matches). Example numbers of matches include at most one match and at most a plurality of matches. For example, Coarse 210 is enabled to detect at most one match (either exact or approximate), and Fine 220 is enabled to detect at most one match (either exact or approximate). For another example, Coarse 210 is enabled to detect at most a plurality of matches (either exact or approximate), and Fine 220 is enabled to detect at most a plurality of matches (either exact or approximate). An example of coarse match sequencing includes parallel processing of all matches (exact or approximate), such as in a single use of Fine Portion 222. Another example of coarse match sequencing includes serial processing of each match (exact or approximate) in a respective single use of Fine Portion 222. E.g., if there are two coarse matches, then in response Fine Portion 222 is used twice in series, once for each of the coarse matches. Following are descriptions of some example combinations of match type, number of matches, and coarse match sequencing.

In some similar variations and/or usage scenarios, a plurality of the sense amps of Sense Amp Circuitry 214 detect a corresponding plurality of exact matches. According to one technique, in response to the plurality of matches, the second phase of operation is repeated serially for each of the exact matches and counting as performed by Post-Process (count) 225 is carried out across the serial repetitions. For example, first, second, and third sense amps of Sense Amp Circuitry 214 each detect an exact match. In response, the second phase of operation is repeated three times (i.e., three repetitions, including a first repetition, a second repetition, and a third repetition), and the counting is performed across the three repetitions. The first repetition begins the counting. The second phase of operation is performed a first time, using the match detected by the first sense amp that detected a match in the first phase of operation. Post-Process (count) 225 initiates counting using results of the second phase of operation as performed in the first repetition to begin the counting. The second repetition continues the counting. The second phase of operation is performed a second time, using the match detected by the second sense amp that detected a match in the first phase of operation. Post-Process (count) 225 continues the counting using results of the second phase of operation as performed in the second repetition to continue the counting by counting results of the second first repetition with results of the previously counted results of the first repetition. The third repetition concludes the counting. The second phase of operation is performed a third time, using the match detected by the third sense amp that detected a match in the first phase of operation. Post-Process (count) 225 concludes the counting using results of the second phase of operation as performed in the third repetition to conclude the counting by counting results of the third repetition with the previously counted results of the first and second repetitions. According to another technique, in response to the plurality of matches, the second phase of operation is performed once, with a plurality of the word lines of Array 250 activated (corresponding to the plurality of exact matches). For example, first, second, and third sense amps of Sense Amp Circuitry 214 each detect an exact match. In response, the second phase of operation is performed one time. Post-Process (count) 225 performs counting using results of the second phase of operation to perform the counting.

In some variations and/or usage scenarios, Coarse 210 is operable as an exactly and approximately matching TCAM. During the first phase of operation, Coarse 210 operates as a TCAM enabled for exact and approximate matching. Thus, zero or more of the sense amps of Sense Amp Circuitry 214 detect matches. In response, the second phase of operation is repeated serially for each of the matches and counting as performed by Post-Process (count) 225 is carried out across the serial repetitions. For one approximate matching technique, the sense amps of Sense Amp Circuitry 214 are enabled to detect changes according to more than one threshold (e.g., in series via different sense durations or in parallel via parallel operation of multiple detection mechanisms). For instance, one threshold corresponds to an exact match, and another threshold corresponds to an approximate match (e.g., all but one or two bits match). Respective amounts of approximate match are implementable via respective thresholds (e.g., via respective sense durations). For instance, a first amount of approximate match (corresponding to two or fewer bits mismatching) is implemented via a first threshold (e.g., via a first sense duration). A second amount of approximate match (corresponding to four or fewer bits mismatching) is implemented via a second threshold (e.g., via a second sense duration greater than the first sense duration).

In some variations and/or usage scenarios, Fine 220 is operable to match stored information exactly and approximately versus search parameters in accordance with word line values. During the second phase of operation, Fine 220 operates to detect exact and approximate matching, thus, zero or more of the sense amps of Sense Amp Circuitry 224 detect matches. Each detection indicates whether the respective match is exact or approximate. Further, techniques such as those described with respect to approximate matching for Coarse 210 are applicable to Fine 220. Post-Process (count) 225 is enabled to count exact and approximate matches accordingly. For example, an exact match counts as a greater value than an approximate match.

Dimensions of Array 250 and apportionment between Coarse Portion 212 and Fine Portion 222 varies according to usage. For example, Coarse Portion 212 has N memory strings and Fine Portion 222 has M memory strings such that Array 250 has N+M memory strings total. Each of the memory strings has L memory devices (in series) in each of the memory strings for a total of L*(N+M) memory devices in Array 250. There are L word lines of Word Line Circuitry 252 coupled to Array 250. Each of the word lines couples to N+M memory devices (in parallel), conceptually across the entire "width" of Array 250. Each of the N memory strings of Coarse Portion 212 are coupled to a respective bit line circuit of Bit Line Circuitry 211 and a respective sense amp of Sense Amp Circuitry 214. Thus, there are N bit line circuits in Bit Line Circuitry 211 and N sense amps in Sense Amp Circuitry 214. Similarly, each of the M memory strings in Fine Portion 222 is coupled to a respective bit line circuit in Bit Line Circuitry 221 and a respective sense amp of Sense Amp Circuitry 224. Thus, there are M bit line circuits in Bit Line Circuitry 221 and M sense amps in Sense Amp Circuitry 224. As a specific example, N=48, M=128K-48, and L=48. As another specific example, N=232, M=128K-232, and L=232.

In some variations, Coarse Search Result(s) 215 is selectively provided elsewhere, e.g., via interface circuitry to a host.

Partitioning of functionality between Sense Amp Circuitry 224 and Post-Process (count) 225 is arbitrary. E.g., variations having some or all functions of Post-Process (count) 225 incorporated in Sense Amp Circuitry 224 and vice-versa are contemplated.

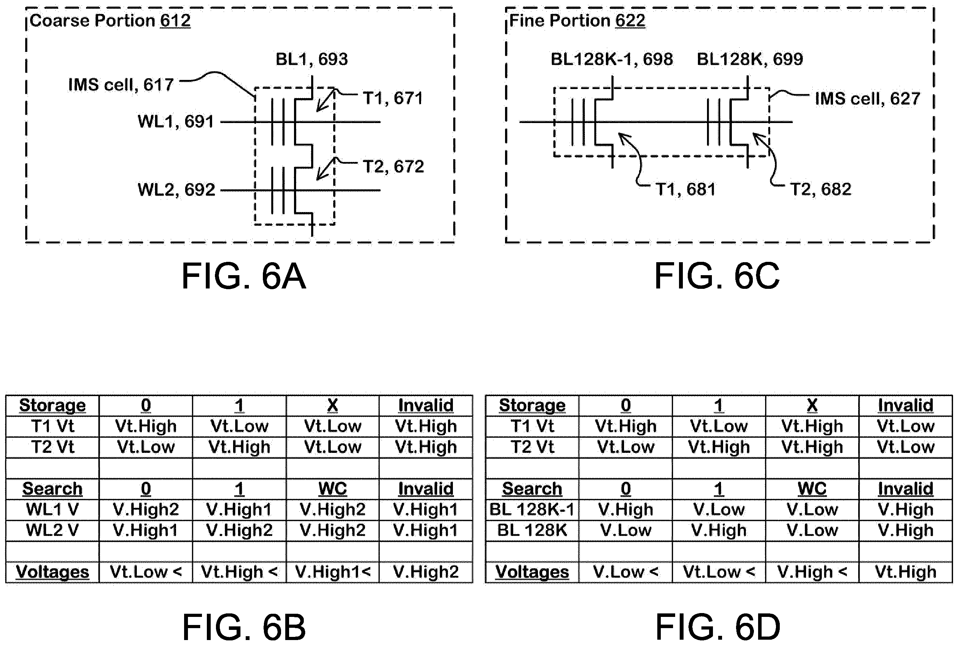

An example implementation of IMS cell (Coarse) 217 is described with respect to Fig. 6A and Fig. 6B. An example implementation of IMS cell (Fine) 227 is described with respect to Fig. 6C and Fig. 6D. In some variations, the pair of devices in IMS cell (Coarse) 217 and/or IMS cell (Fine) 227 are implemented with a pair of SONOS devices.

### Computational Memory -- IMS => IMC

Continuing to the second example of computational memory (an IMS operation followed by an IMC operation), similar to the first example, a single computational memory array has two portions (one for the IMS operation and one for the IMC operation) that are enabled to respectively perform a coarse search (e.g., operate as a TCAM) followed by a computation dependent on results of the coarse search. Conceptually, the coarse search portion implements a filter (e.g., via word line inputs) to reduce computation (e.g., computation via bit line inputs) performed by the computation portion.

As an example of operation, the coarse search portion is similar to that of the first example and is used similarly. Thus, the coarse search portion is operated as a TCAM, and example results are one-hot encoded. Further, matches from the coarse search portion are then used to generate (computation) values for the word lines of the array. Concurrently, bit lines of the computation portion are operated in accordance with computing, such as operated according to respective terms/bits of a first vector input of a dot product. Stored information in memory cells of the computation portion corresponds to respective terms/bits of a second input vector of the dot product.

As a specific example, the TCAM result corresponds to a matched category, the first vector input corresponds to a neuron value, and the second vector input corresponds to a weight to apply to the neuron value. As another specific example, the bit lines of the computation portion are driven to (e.g., analog) voltages representing a first vector input (each bit line voltage corresponding to an element of the first vector). Threshold voltages of the memory cells are programmed to voltages representing a second input vector (each memory cell threshold voltage corresponding to an element of the second vector). Summing (optionally scaled) currents across the bit lines serves to accumulate individual products (bit line voltage multiplied by memory cell current as determined in part by threshold voltage) into a dot product result of the first and second input vectors. One form of scaling is according to powers of two, such as to effectively encode a binary value. Another form of scaling is according to relative importance, such as scaling according to significance of a feature. Some variations produce a single sum across all the bit lines of the computation portion. Other variations produce a plurality of sums corresponding to respective groups of the bit lines of the computation portion.

Sensing in the computing portion is multi-valued and encoded via either digital or analog techniques. For example, in an analog technique, sense amps of the computing portion are responsive to bit line changes and produce an analog output that is then optionally scaled via an analog technique. Then the scaled analog outputs are combined, e.g., via an analog summation to produce a computation result. In the context of the specific example, the computation result corresponds to the dot product result. The computation result is optionally converted to a binary representation.

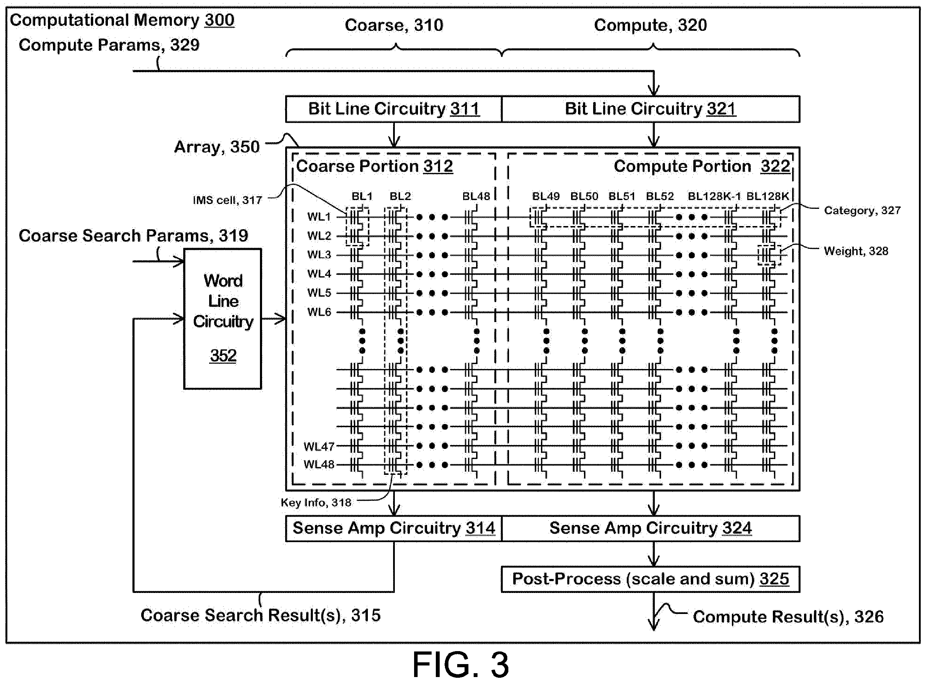

Fig. 3 illustrates an example computational memory for performing a coarse search followed by a computation dependent on results of the coarse search as Computational Memory 300.

Similar to Computational Memory 200 of Fig. 2, Computational Memory 300 comprises two portions, Coarse 310 for performing the coarse search and Compute 320 for performing the computation. Coarse Portion 312 and Compute Portion 322 are portions of a same memory array, Array 350. Word Line Circuitry 352 is enabled to provide results of the coarse search to the computation.

Some elements of Fig. 3 are identical, substantially similar, or similar to corresponding elements of Fig. 2 and for further description thereof, refer to the corresponding elements. For example, Sense Amp Circuitry 314 comprises sense circuitry enabled to determine a current and/or a voltage change of each of the sense amp terminals of Coarse Portion 312, as in Sense Amp Circuitry 214. For another example, IMS cell (Coarse) 317 and Key Info 318 correspond respectively to IMS cell (Coarse) 217 and Key Info 218. As a final example, Bit Line Circuitry 311 comprises bit line circuitry enabled to operate each of the bit line terminals according to a predetermined value as Bit Line Circuitry 211 does. Further, Array 350 corresponds to Array 250, Coarse 310 corresponds to Coarse 210, Compute 320 roughly corresponds to Fine 220 (Post-Process (scale and sum) 325 having different functionality than Post-Process (count) 225), and so forth. An element of Fig. 3 corresponds to an element of Fig. 2 as identified by the final two digits of the element identifier. Thus, the following description focuses on elements of Fig. 3 that are different in operation than the corresponding elements of Fig. 2 or are not present in Fig. 2.

Computational Memory 200 is directed to a coarse search and then a fine search. In contrast, Computational Memory 300 is directed to a coarse search and then a compute. Considering the coarse search, in some variations, Coarse 310 operates identically to Coarse 210. Considering the compute versus the fine search, Compute 320 operates differently than Fine 220. Bit Line Circuitry 321 operates the memory strings of Compute Portion 322 individually, rather than in pairs as exemplified by Bit Line Circuitry 221 (IMS cell (Fine) 227 versus Weight 328). Bit Line Circuitry 321 is optionally enabled to drive the memory strings in accordance with analog values. Compute Portion 322 is optionally enabled to store analog values. Sense Amp Circuitry 324 and Post-Process (scale and sum) 325 are optionally enabled to operate with analog values.

More specifically, Bit Line Circuitry 321 is enabled to operate bit lines independently of each other to respective voltages and/or currents, such as via a conditional precharge technique or via a continuously provided technique. Sense amps of Sense Amp Circuitry 324 are enabled to represent more than two values, via either digital (e.g., a plurality of bits on a respective plurality of terminals) or analog (e.g., different currents on a single terminal) techniques. Post-Process (scale and sum) 325 is enabled to optionally scale sense amp results (voltage or current) according to one or more scale factors. For instance, respective scale factors are applied to respective groups of sense amp outputs of Sense Amp Circuitry 324. One form of scaling is via analog techniques. Another form of scaling is via digital techniques. Post-Process (scale and sum) 325 is further enabled to combine the optionally scaled sense amp outputs, e.g., via analog summation and/or digital summation. One or more outputs of Post-Process (scale and sum) 325 are presented as one or more results via Compute Result(s) 326. In some variations, operation of Sense Amp Circuitry 324 and Post-Process (scale and sum) 325 is combined, such that the combining (e.g., via analog summation) conceptually occurs before some or all sensing, such that a reduced number of sense amps are used. In some variations, outputs of Compute Result(s) 326 are analog and in other variations the outputs are digital.

As in Fine Portion 222, the current and/or the voltage changes of the memory strings of Compute Portion 322 are due, e.g., to selective discharge of the conditionally precharged memory strings based on stored values of the series-coupled memory devices of the memory strings, as well as values provided to the word lines by Word Line Circuitry 352.

Thus, Compute Result(s) 326 encompasses information based on Coarse Search Params 319, information stored in Coarse Portion 312, information based on Compute Params 329, information stored in Compute Portion 322, and summing as performed by Post-Process (scale and sum) 325.

As in Word Line Circuitry 252, Word Line Circuitry 352 is enabled to conditionally operate in two modes during respective first and second phases of operation. The first mode of operation is identical to that of Word Line Circuitry 252. In summary, one or more search parameters (Coarse Search Params 319) are converted pairwise (as conceptually indicated by IMS cell (Coarse) 317) to voltages suitable to perform a coarse search function using the memory strings of Coarse Portion 312 (as conceptually indicated by Key Info 318). In the second mode, one or more results from operation in the first mode, Coarse Search Result(s) 315, are converted to voltages suitable to perform a compute function using the memory strings of Compute Portion 322 (rather than a fine search function as in Fine Portion 222). For example, Word Line Circuitry 352 drives zero or more of the word lines of Array 350 (corresponding to the exact match(es) represented on Coarse Search Result(s) 315) for reading (e.g., provides voltage Vread). Word Line Circuitry 352 drives the remaining word lines of Array 350 for passing (e.g., provides voltage Vpass).

An example of a memory cell used as a weight is illustrated as Weight 328. In some variations, each memory cell used as a weight is implemented with a respective SONOS device, with respective weight values implemented as respective threshold voltages. In some variations, each memory cell used as a weight is implemented using an SLC technique, an MLC technique, a TLC technique, a QLC technique, or an analog technique.

An example of a row of memory cells used as a category is illustrated as Category 327.

In some variations and/or usage scenarios, sub-portions of Compute Portion 322 are used in accordance with respective features, such that a summation in Post-Process (scale and sum) 325 across the entirety of Compute Portion 322 produces an overall scoring across the features. The overall scoring is usable, e.g., as a classification result, such as to rank a number of highest scoring instances. In some variations, Compute 320 serves to perform MAC processing that calculates a likeliness score between an inquiry and selected instances in Compute Portion 322. The selected instances are determined by Coarse 310 and serve to improve efficiency.

### Computational Memory -- IMS => Access

Continuing to the third example of computational memory (an IMS operation followed by an access operation), similar to the first example, a single computational memory array has two portions (one for the IMS operation and one for the access operation) that are enabled to respectively perform a coarse search (e.g., operate as a TCAM) followed by an access operation dependent on results of the coarse search. Conceptually, the coarse search portion implements a filter (e.g., via word line inputs) to reduce access cost (e.g., provide one or more result values) performed by the access portion.

As an example of operation, the coarse search portion is similar to that of the first example and is used similarly. Thus, the coarse search portion is operated as a TCAM, and example results are one-hot encoded. Further, matches from the coarse search portion are then used to generate (access operation) values for the word lines of the array. Concurrently, bit lines of the access operation portion are operated to enable reading a stored value from memory cells of the access operation portion as selected by the word lines. Sense amps of the access operation portion detect the stored values from the selected memory cells and provide, e.g., a page of data.

As a specific example, stored values in the coarse search portion correspond to key values to match an (optionally masked) input key against stored values in the access operation portion correspond to respective values. The coarse search portion is used such that at most one match is found, so only one word line is activated during the access operation. Thus, the computational memory is operable as a key-value store.

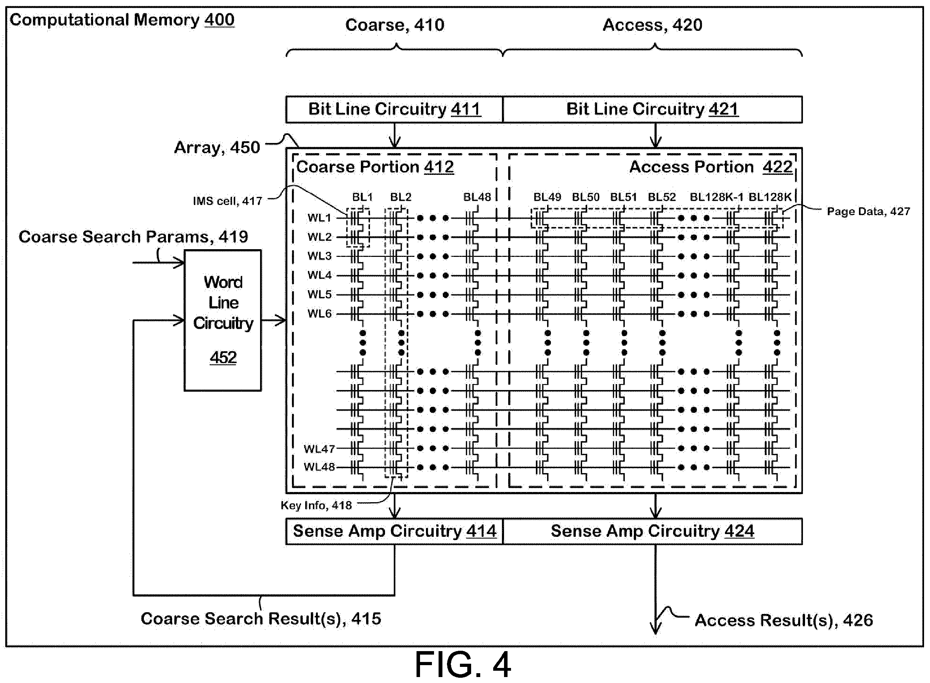

Fig. 4 illustrates an example computational memory for performing a coarse search followed by an access operation dependent on results of the coarse search as Computational Memory 400.

Similar to Computational Memory 200 of Fig. 2, Computational Memory 400 comprises two portions, Coarse 410 for performing the coarse search and Access 420 for performing the access operation. Coarse Portion 412 and Access Portion 422 are portions of a same memory array, Array 450. Word Line Circuitry 452 is enabled to provide results of the coarse search to the access operation.

Some elements of Fig. 4 are identical, substantially similar, or similar to corresponding elements of Fig. 2 and for further description thereof, refer to the corresponding elements. For example, IMS cell (Coarse) 417 and Key Info 418 correspond respectively to IMS cell (Coarse) 217 and Key Info 218. Further, Array 450 corresponds to Array 250, Coarse 410 corresponds to Coarse 210, Access 420 roughly corresponds to Fine 220 (with Bit Line Circuitry 421 lacking an input corresponding to Fine Search Params 229 and Post-Process (count) 225 having no corresponding element in Fine 220), and so forth. As in Fig. 3, an element of Fig. 4 corresponds to an element of Fig. 2 as identified by the final two digits of the element identifier. Thus, the following description focuses on elements of Fig. 4 that are different in operation than the corresponding elements of Fig. 2.

Similar to Word Line Circuitry 252, Word Line Circuitry 452 drives a single one of the word lines of Array 450 (corresponding to the exact match represented on Coarse Search Result(s) 415) for reading (e.g., provides voltage Vread). Word Line Circuitry 452 activates the remaining word lines of Array 450 for passing (e.g., provides voltage Vpass).

Although Bit Line Circuitry 421 topologically corresponds to Bit Line Circuitry 221, it is different in that it operates the bit line terminals of Access Portion 422 according to a predetermined value, e.g., comprising a precharger for each of the bit line terminals (similar to Bit Line Circuitry 211). The prechargers operate (in conjunction with other circuitry, e.g., Word Line Circuitry 452 and/or Sense Amp Circuitry 424) to precharge the memory strings of Access Portion 422.

Sense Amp Circuitry 424 corresponds to Sense Amp Circuitry 224. However, rather than providing the results to another element for further processing, the results are provided directly (e.g., in a binary encoding) as Access Result(s) 426. The results correspond to a selected page of data, an example of which is illustrated as Page Data 427.

Thus, Access Result(s) 426 encompasses information based on Coarse Search Params 419, as well as information stored in Coarse Portion 412 and Access Portion 422.

In some variations of the foregoing computational memories, word lines are continuous across two portions of an array. For example, word lines (e.g., WL1 ... WL48) are continuous across Coarse Portion 212 and Fine Portion 222 (Fig. 2). For other examples, word lines are continuous across Coarse Portion 312 and Compute Portion 322 (Fig. 3) as well as Coarse Portion 412 and Access Portion 422 (Fig. 4). In some variations, word lines of the two portions are driven separately. For example, word lines are not continuous between the two portions.

In some variations of the foregoing computational memories, bit line circuitry and/or sense amp circuitry is segmented between two portions of an array. For example, Bit Line Circuitry 211 and Bit Line Circuitry 221 are two segments of bit line circuitry spanning Coarse Portion 212 and Fine Portion 222 (Fig. 2). For other examples, Bit Line Circuitry 311 and Bit Line Circuitry 321 are two segments of bit line circuitry spanning Coarse Portion 312 and Compute Portion 322 (Fig. 3) and Bit Line Circuitry 411 and Bit Line Circuitry 421 are two segments of bit line circuitry spanning Coarse Portion 412 and Access Portion 422. For similar examples, Sense Amp Circuitry 214 and Sense Amp Circuitry 224 are two segments of sense amp circuitry spanning Coarse Portion 212 and Fine Portion 222 (Fig. 2). For other similar examples, Sense Amp Circuitry 314 and Sense Amp Circuitry 324 are two segments of sense amp circuitry spanning Coarse Portion 312 and Compute Portion 322 (Fig. 3) and Sense Amp Circuitry 414 and Sense Amp Circuitry 424 are two segments of sense amp circuitry spanning Coarse Portion 412 and Access Portion 422. In some of the segmented sense amp circuitry examples, post-sense amp processing is included in a segment of sense amp circuitry. As an example, Sense Amp Circuitry 214 is included in a first segment of sense amp circuitry and Sense Amp Circuitry 224 collectively with Post-Process (count) 225 are included in a second segment of the sense amp circuitry (Fig. 2). As another example, Sense Amp Circuitry 314 is included in a first segment of sense amp circuitry and Sense Amp Circuitry 324 collectively with Post-Process (scale and sum) 325 are included in a second segment of the sense amp circuitry (Fig. 3).

In some variations of the foregoing computational memories, bit lines are precharged, for example, according to a predetermined value or according to a dynamic value, depending on whether the bit lines are being used as inputs. In other variations, the bit lines are driven, rather than precharged, according the predetermined or dynamic values.

In some variations of the foregoing computational memories, each memory cell is enabled to store one or a plurality of symbols, e.g., via binary or analog techniques. For example, a memory cell is enabled to store a single symbol as an analog value, such as a device threshold voltage. As a specific example, programming a threshold voltage of a SONOS cell is usable for (e.g., analog) data storage. For another example, a memory cell is enabled to store a single symbol, e.g., interpreted as a single bit of information, using an SLC technique. For other examples, a memory cell is enabled to store a plurality of symbols, using an MLC, TLC, or QLC technique.

In some variations of the foregoing computational memories, a page buffer (implemented, e.g., as page buffer circuitry) and/or a page cache (implemented, e.g., as page cache circuitry) is used to store results. For example, Fine Search Result(s) 226 is stored in a page buffer associated with Fine Portion 222 (Fig. 2). For other examples, Compute Result(s) 326 is stored in a page buffer associated with Compute Portion 322 (Fig. 3) and Access Result(s) 426 is stored in a page buffer and/or page cache associated with Access Portion 422 (Fig. 4). For another example, Access Result(s) 426 is stored in page cache circuitry coupled to Sense Amp Circuitry 424. The page cache circuitry is enabled to cache a page of results read from Access Portion 422. The page of results corresponds, e.g., to information stored in Page Data 427.

### Computational Memory Device

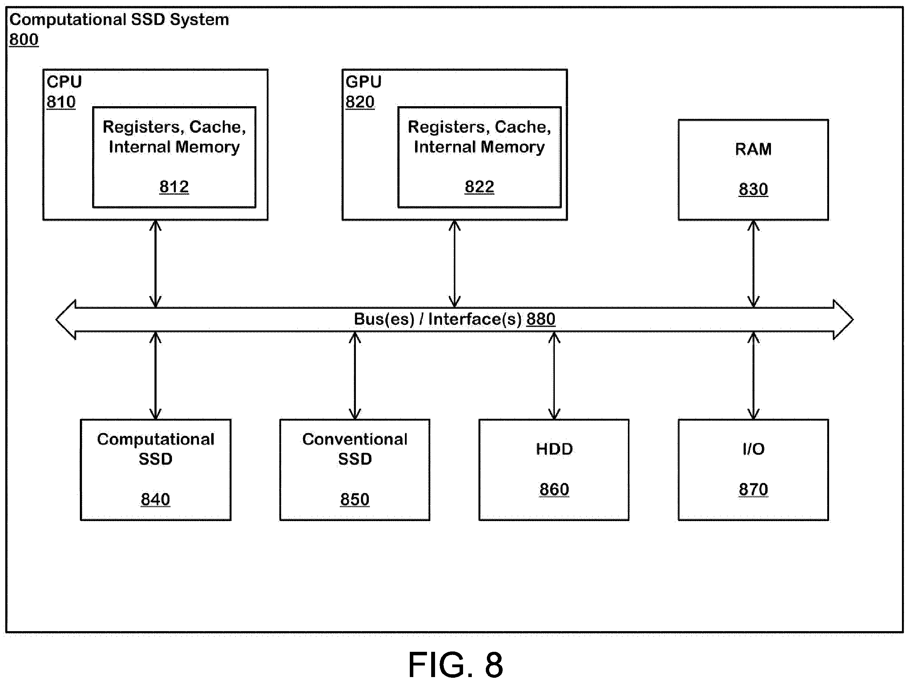

Some elements (e.g., integrated circuits, one or more die of a system-on-a-chip, and/or packaged die) comprise one or more computational memories (such as Computational Memory 200 of Fig. 2, Computational Memory 300 of Fig. 3, and/or Computational Memory 400 of Fig. 4) with one or more optional hardware circuitry blocks to implement a memory component usable as a stand-alone component and/or usable as a component in a system. For example, the hardware circuitry enables use of the computational memories in a computational SSD (such as Computational SSD 700 of Fig. 7 as Configurable Computational Memory Device 765 and/or Computational SSD 840 of Fig. 8). For another example, the optional hardware circuitry blocks enable use of the computational memories as components of a system-on-a-chip.

Example optional hardware circuitry blocks are an I/O interface, a controller, and an analog source.

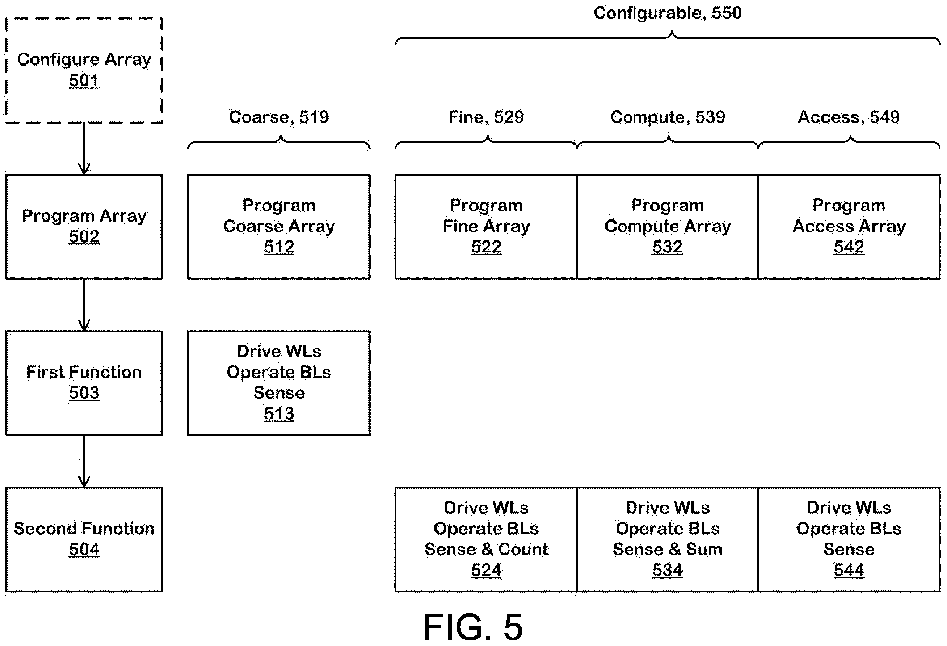

The I/O interface is enabled to interface an agent external to the computational memories (such as a host) to use the computational memory. Example uses are configuring arrays of the computational memories (such as Configure Array 501 of Fig. 5), programming arrays of the computational memories (such as Program Array 502 of Fig. 5), directing the computational memories to perform a first function and optionally receive results of the first function (such as First Function 503 of Fig. 5), and directing the computational memories to perform a second function and optionally receive results of the second function (such as Second Function 504 of Fig. 5).

The controller is enabled to provide overall control of operations of and between various hardware circuitry blocks of one or more of the computational memories. For example, the controller coordinates operation of the I/O interface with portions of memory arrays of the computational memories. For another example, the controller coordinates operation of the analog source with respect to configuration information. For another example, the controller optionally coordinates sequencing of a second function that is dependent on a first function.

The analog source is enabled to generate and/or provide one or more analog outputs to, e.g., memory arrays, bit line circuitry, sense amp circuitry, and/or word line circuitry of the computational memories. The analog outputs comprise zero or more voltage and/or current sources (such as reference sources), for instance as generated by one or more bias circuits.

### Computational Memory Operation

Fig. 5 illustrates an example flow diagram for a technique to operate a computational memory, such as with regards to computational SSD techniques illustrated or referred to in any of the other figures.

Flow proceeds in four actions: Configure Array 501, Program Array 502, First Function 503, and Second Function 504. The flow is for one of three types of dedicated arrays, as well as an array that is configurable according to any one or more of the three types of dedicated arrays. Flow for each of the types of dedicated arrays is described and then flow for a configurable array is described.

Flow for any of the three types of dedicated arrays begins with Program Array 502. Consider an array dedicated to a first IMS (coarse search) followed by a second IMS (fine search) dependent on the first search (such as Array 250 of Fig. 2). Details of the flow are illustrated by actions of Coarse 519 and Fine 529.

Flow begins with Program Array 502 by storing values into respective portions of the dedicated array. A coarse search portion of the array is programmed with values to be searched for a match against using the coarse search portion of the array (Program Coarse Array 512). A fine search portion of the array is programmed with values to store and match against search information supplied via bit lines of the fine search portion of the array (Program Fine Array 522).

Subsequently, flow proceeds to First Function 503. A first of two functions (corresponding to the coarse search) is performed using the coarse search portion of the array. Word lines of the array are driven and bit lines of the coarse search portion of the array are operated and sensed (Drive WLs; Operate BLs; Sense 513). More specifically, the word lines of the array are driven according to coarse search information (e.g., key information and optionally a mask). The bit lines of the coarse search portion of the array are operated according to a predetermined value that enables the coarse search portion of the array to operate as a readable memory with respect to the word lines and the values programmed in the coarse search portion of the array. The bit lines of the coarse search portion of the array are sensed to determine matches between the word lines and the values programmed as results of the first function. The results of first function (the coarse search) are provided for use by the second function.

Subsequently, flow proceeds to Second Function 504. A second of the two functions (the fine search) is performed using the fine search portion of the array. Word lines of the array are driven and bit lines of the fine search portion of the array are operated, sensed, and counted (Drive WLs; Operate BLs; Sense and Count 524). More specifically, the word lines are driven according to the results of the coarse search. The bit lines of the fine search portion of the array are operated according to respective dynamic values provided as a search parameter that the fine search portion of the array searches for (in parallel) among the stored values of the fine search portion of the array. The bit lines of the fine search portion of the array are sensed to determine matches, and then the matches are counted (e.g., in one or more groups) to determine overall one or more highest matches as results of the second function. The results of the second function (the fine search) are then available for use by other agents. Thus, flow for the array dedicated to a first IMS followed by a second IMS is complete.

Consider next an array dedicated to an IMS (coarse search) followed by an IMC (computing) dependent on the IMS (such as Array 350 of Fig. 3). Details of the flow are illustrated by actions of Coarse 519 and Compute 539.

As with the array dedicated to first and second IMS searches, flow begins with Program Array 502 by storing values into respective portions of the dedicated array. A coarse search portion of the array is programmed with values to be searched for a match against using the coarse search portion of the array (Program Coarse Array 512). A compute portion of the array is programmed with values to store and compute with a compute parameter supplied via bit lines of the compute portion of the array (Program Compute Array 532).

As with the array dedicated to first and second IMS searches, flow subsequently proceeds to First Function 503 to perform the first function by driving word lines and operating and sensing bit lines of the coarse search portion of the array (Drive WLs; Operate BLs; Sense 513). Results of first function (the coarse search) are provided for use by the second function.

As with the array dedicated to first and second IMS searches, flow subsequently proceeds to Second Function 504. A second of the two functions (the compute) is performed using the compute portion of the array. Word lines of the array are driven and bit lines of the compute portion of the array are operated, sensed, and summed (Drive WLs; Operate BLs; Sense and Sum 534). More specifically, the word lines of the array are driven according to the results of the coarse search. The bit lines of the compute portion of the array are operated according to respective dynamic values provided as a compute parameter that the compute portion of the array uses as a compute operand (in parallel) with the stored values of the compute portion of the array. The bit lines of the compute portion of the array are sensed to determine respective intermediate results (e.g., as respective analog currents or voltages). The intermediate results are then combined (e.g., summed using an analog technique) to produce one or more results of the second function. The results are optionally converted to a digital representation. In some variations, the sensing and summing are performed together. The results of the second function (the compute) are then available for use by other agents. Thus, flow for the array dedicated to an IMS followed by an IMC is complete.

Consider next an array dedicated to an IMS (coarse search) followed by an access operation dependent on the IMS (such as Array 450 of Fig. 4). Details of the flow are illustrated by actions of Coarse 519 and Access 549.

As with the array dedicated to first and second IMS searches, flow begins with Program Array 502 by storing values into respective portions of the dedicated array. A coarse search portion of the array is programmed with values to be searched for a match against using the coarse search portion of the array (Program Coarse Array 512). An access operation portion of the array is programmed with values to store and be available for reading by a subsequent access operation (Program Access Array 542).

As with the array dedicated to first and second IMS searches, flow subsequently proceeds to First Function 503 to perform the first function by driving word lines and operating and sensing bit lines of the coarse search portion of the array (Drive WLs; Operate BLs; Sense 513). Results of first function (the coarse search) are provided for use by the second function.

As with the array dedicated to first and second IMS searches, flow subsequently proceeds to Second Function 504. A second of the two functions (the access operation) is performed using the access operation portion of the array. Word lines of the array are driven and bit lines of the access operation portion of the array are operated and sensed (Drive WLs; Operate BLs; Sense 544). More specifically, the word lines are driven according to the results of the coarse search. The bit lines of the access operation portion of the array are operated according to a predetermined value that enables the access operation portion of the array to operate as a readable memory with respect to the word lines and the values programmed in the fine search portion of the array. The bit lines of the access operation portion of the array are sensed to determine respective digital results that collectively form one or more results of the second function. The results of the second function (the access operation) are then available for use by other agents. Thus, flow for the array dedicated to an IMS followed by an access operation is complete.

Flow for the configurable array begins with action Configure Array 501. The configurable array (such as a configurable combination of elements of Fig. 2, Fig. 3, and/or Fig. 4) is configured according to apportionment dedicated to each respective type of operation: fine search, computation, and access operation.

Then flow proceeds individually for each apportionment (optionally in parallel) according to configuration as illustrated by Configurable 550. Thus, for each apportionment configured as a first IMS (coarse search) followed by a second IMS (fine search) dependent on the first IMS search, flow proceeds according to Coarse 519 and Fine 529. For each apportionment configured as a first IMS (coarse search) followed by an IMC (computing) dependent on the IMS search, flow proceeds according to Coarse 519 and Compute 539. For each apportionment configured as a first IMS (coarse search) followed by an access operation dependent on the IMS, flow proceeds according to Coarse 519 and Access 549.

### Example Word Line and Bit Line Based Searching

Fig. 6A and Fig. 6B collectively illustrate searching via information provided on word lines. Fig. 6C and Fig. 6D collectively illustrate searching via information provided on bit lines.

Turning first to Fig. 6A, Fig. 6B, and searching via word lines, Coarse Portion 612 and IMS cell (Coarse) 617 correspond respectively to Coarse Portion 212 and IMS cell (Coarse) 217 of Fig. 2 (although Fig. 6A omits some details illustrated in Fig. 2). T1 671 and T2 672 are in series on BL1 693, coupled respectively to word lines WL1 691 and WL2 692. Fig. 6B illustrates an example of threshold voltages to program T1 671 and T2 672 with and search voltages to drive WL1 691 and WL2 692 with to enable matching search information against stored information.

The threshold voltages for T1 671 and T2 672 illustrated in Fig. 6B specify encoding to enable matching against only a zero ("0"), only a one ("1"), anything ("X"), and nothing ("Invalid"). The search voltages for WL1 691 and WL2 692 illustrated in Fig. 6B specify encoding to enable search for only a zero "0", only a one ("1"), anything / WildCard ("WC"), and nothing ("Invalid"). As one specific example, to match against a zero, T1 671 is programmed to a threshold voltage of Vt.High and T2 672 is programmed to a threshold voltage of Vt.Low. To search for a zero, WL1 691 is driven to V.High2 and WL2 692 is driven to V.High1. The last line of the table in Fig. 6B illustrates an example relationship between the two threshold voltages Vt.Low and Vt.High as well as the two search voltages V.High1 and V.High2. Specifically, the two threshold voltages (Vt.Low and Vt.High) are lower than either of the two search voltages (V.High1 and V.High2). Stated another way, the two search voltages are higher than either of the two threshold voltages. Additionally, Vt.Low is a lower voltage than Vt.High and V.High1 is a lower voltage than V.High2. For a specific example, Vt.Low (the lowest voltage) is -1V, Vt.High is 3V, V.High1 is 4V, and V.High2 (the highest voltage) is 5V.

In operation, pairs of memory devices of a coarse portion of a memory array (e.g., memory devices of BL1 ... BL48 of Coarse Portion 212 of Fig. 2), are programmed with data to search for in accordance with Fig. 6B. The programming is performed, e.g., as part of Program Coarse Array 512 of Fig. 5. Then a search is performed in accordance with driving pairs of word lines (e.g., WL1, WL2 ... WL47, WL48 of Fig. 2) according to Fig. 6B. The search is performed as part of Drive WLs; Operate BLs; Sense 513 of Fig. 5.

Turning next to Fig. 6C, Fig. 6D, and searching via bit lines, Fine Portion 622 and IMS cell (Fine) 627 correspond respectively to Fine Portion 222 and IMS cell (Fine) 227 of Fig. 2 (although Fig. 6C omits some details illustrated in Fig. 2). T1 681 and T2 682 are coupled to respective bit lines BL128K-1 698 and BL128K 699 and share a word line. Fig. 6D illustrates an example of threshold voltages to program T1 681 and T2 682 with and search voltages to drive BL128K-1 698 and BL128K 699 with to enable matching search information against stored information.

Similar to Fig. 6B, the threshold voltages for T1 681 and T2 682 illustrated in Fig. 6D specify encoding to enable matching against only a zero ("0"), only a one ("1"), anything ("X"), and nothing ("Invalid"). The search voltages for BL128K-1 698 and BL128K 699 illustrated in Fig. 6D specify encoding to enable search for only a zero "0", only a one ("1"), anything / WildCard ("WC"), and nothing ("Invalid"). As one specific example, to match against a zero, T1 681 is programmed to a threshold voltage of Vt.High and T2 682 is programmed to a threshold voltage of Vt.Low. To search for a zero, BL128K-1 698 is driven to V.High and BL128K 699 is driven to V.Low. The last line of the table in Fig. 6D illustrates an example relationship between the threshold voltages Vt.Low and Vt.High as well as the search voltages V.Low and V.High. Specifically, the two threshold voltages (Vt.Low and Vt.High) are intermixed with respect to voltage levels between the two search voltages (V.Low and V.High). V.Low is the lowest voltage, Vt.Low is the next higher voltage, V.High is the next higher voltage, and Vt.High is the highest voltage. As a specific example, V.Low is 0V, Vt.Low is 1V, V.High is 2V, and Vt.High is 3V.

In operation, pairs of memory devices of a fine portion of a memory array (e.g., memory devices of BL49, BL50 ... BL128K-1, BL128K of Fig. 2), are programmed with data to search for in accordance with Fig. 6D. The programing is performed, e.g., as part of Program Fine Array 522 of Fig. 5. Then a search is performed in accordance with driving pairs of bit lines (e.g., BL128K-1 and BL128K of Fig. 2) according to Fig. 6D. The search is performed, e.g., as part of Drive WLs; Operate BLs; Sense and Count 524 of Fig. 5.

As an example of word line encoding (e.g., as in Fig. 6B), search information is a binary key value, and only search for a zero and a one is enabled. As another example, search information is a binary key value in conjunction with a binary mask value of equal length to the binary key value. Each bit in the binary mask value indicates whether the corresponding bit in the binary key value is to be ignored, e.g., match anything, or match according to the corresponding binary key value bit. As yet another example, building upon the previous example, another binary mask value is further used to indicate whether the corresponding bit in the binary key value is to be considered invalid, e.g., matching nothing. For instance, a 4-bit key value is 0b0111 and a corresponding mask value is 0b0001, resulting in a search for 0b011x, so that a match is made against stored values of 0b110 or 0b0111. Similar examples of bit line encoding (e.g., as in Fig. 6D) use a search value alone, a search value in conjunction with a mask value, and/or a search value in conjunction with a plurality of mask values. For instance, a 4-bit search (e.g., key) value is 0b1010 and a corresponding mask value is 0b1000, resulting in a search for 0bx010, so that a match is made against stored values of 0b1010 or 0b0010.

### Computational SSD

Computational SSD resources are usable in various systems (such as systems using Smart SSDs), such as compute servers, database servers, IMS servers, IMC servers, and AI accelerators.

Fig. 7 illustrates an example computational SSD as Computational SSD 700.

Computational SSD 700 comprises at least one instance of a computational memory device, e.g., at least one of Computational Memory Device 762, Computational Memory Device 763, Computational Memory Device 764, or Configurable Computational Memory Device 765. Note that respective instances of Coarse Search 710, Fine Search 720, Compute 730, and Access 740 are similar, substantially similar, or identical to each other, according to configuration.

Computational Memory Device 762 is directed to implementing fine search capabilities and comprises a memory array operable as two portions to implement Coarse Search 710 that provides information to Second Function 752 to implement Fine Search 720. Computational Memory Device 762 is usable, e.g., in systems directed to providing large scale search capabilities, such as database servers.

Computational Memory Device 763 is directed to implementing compute capabilities and comprises a memory array operable as two portions to implement Coarse Search 710 that provides information to Second Function 753 to implement Compute 730. Computational Memory Device 763 is usable, e.g., in servers directed to providing large scale compute capabilities, such as AI systems.

Computational Memory Device 764 is directed to implementing access capabilities and comprises a memory array operable as two portions to implement Coarse Search 710 that provides information to Second Function 754 to implement Access 740. Computational Memory Device 764 is usable, e.g., in servers directed to providing key-value information, such as key-value SSD-based systems.

Configurable Computational Memory Device 765 is directed to configurable computational SSD capabilities, such as usable, for example, in database servers, AI, systems, and/or key-value SSD-based systems, according to configuration. Configurable Computational Memory Device 765 comprises a memory array operable as two portions to implement Coarse Search 710 that provides information to Configurable Second Function 755 to implement a configuration-determined one of Fine Search 720, Compute 730, and Access 740.

Interface 780 interfaces the computational memory devices to a host and/or a bus, via Host/Bus Coupling 782.

Computational SSD 700 is an example implementation of Computational SSD 840 of Fig. 8, with Host/Bus Coupling 782 serving to couple to Bus(es)/Interface(s) 880 of Fig. 8.

Coarse Search 710 is exemplified by Coarse 210 of Fig. 2, Coarse 310 of Fig. 3, and/or Coarse 410 of Fig. 4.

Fine Search 720 is exemplified by Fine 220 of Fig. 2. Compute 730 is exemplified by Compute 320 of Fig. 3. Access 740 is exemplified by Access 420 of Fig. 4.

Other partitionings of elements, coupling between elements, and capabilities and/or capacities of elements illustrated in the figure are contemplated, as well as additional elements, according to usage requirements.

### Computational SSD System

Fig. 8 illustrates an example hardware system having a computational SSD as Computational SSD System 800. The system comprises hardware blocks CPU 810, GPU 820, RAM 830, Computational SSD 840, Conventional SSD 850, HDD 860, and I/O 870 that are coupled by hardware block Bus(es)/Interface(s) 880.

Computational SSD 840 comprises one or more instances of Computational SSD 700 of Fig. 7.

CPU 810 comprises one or more processing units, such as any combination of hardware units enabled to execute programmed instructions, microprocessors, signal processors, AI processors, and the like. One or more of the processing units optionally comprise one or more internal registers (some of which are optionally architecturally visible), one or more cache memories, and/or one or more internal memories (such as relating to buffering and/or coalescing), as represented by Registers, Cache, and Internal Memory 812.

GPU 820 comprises one or more processing units, such as any combination of units enabled to accelerate processing for processing that is subject to relatively highly parallel processing, such as graphics processing, signal processing, and/or AI processing. Similar to Registers, Cache, and Internal Memory 812 of CPU 810, one or more of the processing units optionally comprise one or more internal registers (some of which are optionally architecturally visible), one or more cache memories, and/or one or more internal memories (such as relating to buffering and/or coalescing), as represented by Registers, Cache, and Internal Memory 822.

RAM 830 comprises one or more storage elements for storage of instructions and/or data in greater quantities than storage internal to CPU 810 and/or GPU 820. RAM 830 is implementable, e.g., via volatile memory elements, such as DRAMs and/or SRAMs.

Conventional SSD 850 comprises one or more storage elements, such as flash-based storage elements for storage of instructions and/or data optionally accessible with reduced latency compared to HDD 860.

HDD 860 comprises one or more storage elements, such as rotation-based magnetic and/or optical non-volatile storage elements (e.g., disks) for storage of instructions and/or data optionally in greater quantities than Conventional SSD 850 is enabled to store.

I/O 870 comprises elements to interface any combination of CPU 810, GPU 820, RAM 830, Computational SSD 840, Conventional SSD 850, and/or HDD 860 to elements external to Computational SSD System 800. Example external elements include mass storage devices, local and wide-area networks (such as the Internet), human interface components (such as keyboards, mice, and/or monitors), and other elements providing capabilities to extend and/or augment capabilities not otherwise provided by Computational SSD System 800.

Bus(es)/Interface(s) 880 enables communication between the elements coupled to it (e.g., CPU 810, GPU 820, RAM 830, Computational SSD 840, Conventional SSD 850, HDD 860, and/or I/O 870). I/O 870 variously comprises one or more serial and/or parallel communication channels as well as optional protocol conversion and/or adaptation capabilities to facilitate communication between the elements coupled to it.

Conceptually, various storage elements in Computational SSD System 800 comprise a memory hierarchy, such as to reduce overall instruction and/or data access time, to reduce overall cost of instruction and/or data storage, and/or to reduce power consumption relating to storage capabilities. For example, Registers, Cache, and Internal Memory 812 of CPU 810 and Registers, Cache, and Internal Memory 822 of GPU 820 collectively comprise a highest level of a memory hierarchy. The memory hierarchy further comprises (from higher to lower levels) RAM 830, Conventional SSD 850, HDD 860, and optionally storage accessible via I/O 870 (such as web site information accessible via the Internet). In the example, higher levels of the memory hierarchy have lower latency and lower capacity than lower levels. E.g., Registers, Cache, and Internal Memory 812 and Registers, Cache, and Internal Memory 822 have lower access latency and/or storage capacity than RAM 830. RAM 830, in turn, has lower access latency and/or storage capacity than Conventional SSD 850, and so forth.

In a first variation of the example, Computational SSD 840 comprises a level of the memory hierarchy between RAM 830 and Conventional SSD 850 and/or HDD 860, bridging the gap in access latency and/or storage capacity. In a second variation of the example, any one or more of Registers, Cache, and Internal Memory 812, Registers, Cache, and Internal Memory 822, RAM 830, Conventional SSD 850, HDD 860, and/or storage accessible via I/O 870, is augmented by elements based on techniques of Computational SSD 840 to decrease access latency and/or increase storage capacity. In other examples, various combinations of SCM, NVDIMM, CXL memory, SSD, and/or DRAM-like storage are implemented using techniques of Computational SSD 840. In yet other examples, Computational SSD 840 enables reductions in processing load (e.g., on CPU 810 and/or GPU 820) and/or reductions in traffic on Bus(es)/Interface(s) 880 by performing processing locally.

Other partitionings of elements, coupling between elements, and capabilities and/or capacities of elements illustrated in the figure are contemplated, as well as additional elements, according to usage requirements.

### Computational SSD Additional Information

Fig. 2, Fig. 3, and Fig. 4 illustrate technology applicable to architectures for computational SSDs. Other technology is also applicable, such as according to different memory technologies.

Example memory technologies applicable to memory arrays of computational SSDs as disclosed herein include floating-gate, split-gate, SONOS, floating dot, DRAM, DRAM-like (e.g., 2T0C), FeFET, and any memory technology compatible with search via word lines and bit lines. Exemplary SONOS memory technology (sometimes referred to as charge trap memory) uses an insulating layer (e.g., of silicon nitride) with traps to capture and retain charge as injected from a channel. Exemplary floating dot memory technology conceptually replaces a floating gate with a floating silicon nanodot or embeds floating silicon nanodots in a polysilicon gate. Exemplary 2T0C memory technology uses parasitic capacitance of a read transistor to store charge rather than an explicit storage capacitor. Exemplary FeFET memory technology uses permanent electrical field polarization of ferroelectric material embedded between a gate and a source-gate conduction region to store information. Example memory structures applicable to memory arrays of computational SSDs include 2D structures (e.g., 2D flash structures) and 3D structures (e.g., 3D flash structures). Example array architectures applicable to memory arrays of computations SSDs include NOR/OR-type array architectures and AND/NAND-type array architectures.

It is understood that the foregoing disclosure presents implementations, variations, embodiments, and examples in an intended illustrative sense rather than in a limiting sense.

## Claims

1. A memory system (100, 800) comprising:
a memory array (250, 350, 450) comprising first (212, 312, 412, 612) and second portions (222, 322, 422, 622) of memory strings, one or more of the memory strings of the first portion (212, 312, 412, 612) of memory strings and one or more of the memory strings of the second portion (222, 322, 422, 622) of memory strings comprising respective pluralities of series-connected memory devices;
word line circuitry (252, 352, 452) having terminals coupled to respective control inputs of respective rows according to which the memory strings are organized;
bit line circuitry (211, 221, 311, 321, 411, 421) having terminals coupled to respective bit line terminals of the memory strings; and
sense amplifier circuitry (214, 224, 314, 324, 414, 424) having terminals coupled to terminals of the memory strings;
wherein the word line circuitry (252, 352, 452) is enabled to selectively drive the control inputs according to one of first and second word line control values, the first word line control values corresponding to a provided value and the second word line control values corresponding to results produced by the sense amplifier circuitry (214, 224, 314, 324, 414, 424) based on information provided via the terminals coupled to the bit line terminals of the first portion (212, 312, 412, 612) of the memory strings,
wherein the terminals of the bit line circuitry (211, 221, 311, 321, 411, 421) coupled to the bit line terminals of the first portion (212, 312, 412, 612) of memory strings are enabled to provide a predetermined operating condition to the first portion (212, 312, 412, 612) of memory strings;
**characterized in that**
the terminals of the bit line circuitry (211, 221, 311, 321, 411, 421) coupled to the bit line terminals of the second portion (222, 322, 422, 622) of memory strings are enabled to provide respective dynamic values to the second portion (222, 322, 422, 622) of memory strings, wherein
dynamic operating conditions including at least one of a fine search (529), a computing (539) and an access operation (549), are produced by operating bit line circuitry terminals of the second portion (222, 322, 422, 622) of memory strings according to the respective dynamic values.

2. The memory system (100, 800) of claim 1, further comprising counting circuitry (225) coupled to the sense amplifier circuitry (224) and enabled to count exact matches between values stored in the second portion (222) of memory strings and the respective dynamic values.

3. The memory system (100, 800) of claim 1 or 2, further comprising summing circuitry (325) coupled to the sense amplifier circuitry (324) and enabled to sum in accordance with currents of the second portion (322) of memory strings, the respective dynamic values are analog values, values stored in the second portion (222, 322, 422, 622) of memory strings are analog values, and the summing circuitry is operable according to an analog technique, the summing circuitry is further enabled to scale the currents prior to summing.

4. The memory system (100, 800) of anyone of the claims 1 to 3, further comprising one or more processors (110, 810) enabled to access the memory array (250, 350, 450), or comprising one or more processors (110, 810) enabled to access a computational solid state drive (SSD) comprising the memory array (250, 350, 450) comprising at least one memory device.

5. The memory system (100, 800) of anyone of the claims 1 to 4, wherein the terminals of the bit line circuitry (211, 221, 311, 321, 411, 421) coupled to the bit line terminals of the second portion (222, 322, 422, 622) of memory strings are further enabled to provide the same predetermined operating condition to the bit line terminals of the second portion (222, 322, 422, 622) of memory strings and further comprising page cache circuitry coupled to the sense amplifier circuitry (214, 224, 314, 324, 414, 424) and enabled to cache a page of results read from values stored in the second portion (222, 322, 422, 622) of memory strings.

6. The memory system (100, 800) of anyone of the claims 1 to 5, wherein the bit line circuitry (211, 221, 311, 321, 411, 421) is enabled to provide a same predetermined operating condition to the bit line terminals, the provided value comprises a key and a mask, and the selective driving of the control inputs comprises selectively driving the control inputs in respective pairs according to a plurality of encodings respectively determined from a respective bit of the key and a corresponding respective bit of the mask, and (i) a first of the encodings enables selectively matching a stored zero value responsive to the provided value being zero, (ii) a second of the encodings enables selectively matching a stored one value responsive to the provided value being one, (iii) a third of the encodings enables selectively matching a stored zero value or a stored one value responsive to the provided value being zero or one, and (iv) a fourth of the encodings disables selectively matching any stored value to the provided value.

7. A method for operating a memory system (100, 800) of anyone of the claims 1 to 6, the method comprising:
first sensing a first portion (212, 312, 412, 612) of memory strings of a memory array (250, 350, 450) according to (i) first voltages driven on word lines (WL1, WL2,...WL48) of the memory array (250, 350, 450), and (ii) predetermined operating conditions of the first portion (212, 312, 412, 612) of memory strings;
second sensing a second portion (222, 322, 422, 622) of memory strings of the memory array (250, 350, 450) according to (i) second voltages driven on word lines (WL1, WL2,...WL48) of the memory array (250, 350, 450), and (ii) dynamic operating conditions of the second portion (222, 322, 422, 622) of memory strings; and
providing results of the second sensing,
wherein the second voltages are based on results of the first sensing;
wherein the dynamic operating conditions are produced by operating bit line circuitry terminals of the second portion (222, 322, 422, 622) of memory strings according to a dynamic value,
wherein the dynamic operating conditions are selected from at least one of a fine search (529), a computing (539) and an access operation (549).

8. The method of claim 7, wherein the second sensing comprises counting approximate matches between values stored in the second portion (222, 322, 422, 622) of memory strings and the dynamic value.

9. The method of claim 7 or 8, wherein the second sensing comprises summing in accordance with currents of the second portion (222, 322, 422, 622) of memory strings, the dynamic value is an analog value, values stored in the second portion (222, 322, 422, 622) of memory strings are analog values, and the summing is according to an analog technique, the second sensing comprises scaling and then summing the currents of the second portion (222, 322, 422, 622) of memory strings.

10. The method of claim 7, wherein the dynamic operating conditions are based on a dynamic value and a mask value to enable matching the dynamic value with any value stored in any of the second portion (222, 322, 422, 622) of memory strings.

11. The method of claim 7, wherein the dynamic operating conditions are based on a dynamic value and a mask value to disable matching the dynamic value with any value stored in any of the second portion (222, 322, 422, 622) of memory strings.

12. The method of anyone of the claims 7 to 11, wherein the results of the second sensing are indicative of a multiply-accumulate operation, a first operand of the multiply-accumulate operation is a dynamic value according to which the dynamic operating conditions are determined, and a second operand of the multiply-accumulate operation corresponds to values programmed into the second portion (222, 322, 422, 622) of memory strings.

13. The method of anyone of the claims 7 to 11, wherein the dynamic operating conditions are determined according to a dynamic value and the results of the second sensing are indicative of a search operation for the dynamic value among values programmed into the second portion (222, 322, 422, 622) of memory strings.

## Patentansprüche

1. Speichersystem (100, 800), welches aufweist:
ein Speicheranordnung (250, 350, 450), die einen ersten Abschnitt (212, 312, 412, 612) und einen zweiten Abschnitt (222, 322, 422, 622) an Speichersträngen aufweist, wobei eine oder mehrere der Speicherstränge des ersten Abschnitts (212, 312, 412, 612) der Speicherstränge und eine oder mehrere der Speicherstränge des zweiten Abschnitts (222, 322, 422, 622) der Speicherstränge jeweils mehrere in Reihe geschaltete Speicherbausteine aufweisen,
eine Wortleitungsschaltung (252, 352, 452), die Anschlüsse aufweist, die mit entsprechenden Steuereingängen entsprechender Reihen verbunden sind, nach denen die Speicherstränge organisiert sind,
eine Bitleitungsschaltung (211, 221, 311, 321, 411, 421), die Anschlüsse aufweist, die mit entsprechenden Bitleitungsanschlüssen der Speicherstränge verbunden sind, und
eine Leseverstärkerschaltung (214, 224, 314, 324, 414, 424), die Anschlüsse aufweist, die mit Anschlüssen der Speicherstränge verbunden sind,
wobei die Wortleitungsschaltung (252, 352, 452) dazu ausgelegt ist, die Steuereingänge entsprechend einem ersten oder einem zweiten Wortleitungssteuerwert selektiv anzusteuern, wobei die ersten Wortleitungssteuerwerte einem vorgegebenen Wert entsprechen und die zweiten Wortleitungssteuerwerte Ergebnissen entsprechen, die von der Leseverstärkerschaltung (214, 224, 314, 324, 414, 424) erzeugten Ergebnissen entsprechen, die auf Informationen basieren, die über die Anschlüsse bereitgestellt werden, die mit den Bitleitungsanschlüssen des ersten Abschnitts (212, 312, 412, 612) der Speicherstränge verbunden sind, **dadurch gekennzeichnet, dass**
die Anschlüsse der Bitleitungsschaltung (211, 221, 311, 321, 411, 421), die mit den Bitleitungsanschlüssen des ersten Abschnitts (212, 312, 412, 612) der Speicherstränge verbunden sind, dazu ausgelegt sind, einen vorbestimmten Betriebszustand für den ersten Abschnitt (212, 312, 412, 612) der Speicherstränge bereitzustellen,
wobei die Anschlüsse der Bitleitungsschaltung (211, 221, 311, 321, 411, 421), die mit den Bitleitungsanschlüssen des zweiten Abschnitts (222, 322, 422, 622) der Speicherstränge verbunden sind, aktiviert worden sind, um dem zweiten Abschnitt (222, 322, 422, 622) der Speicherstränge bereitzustellen, wobei
dynamische Betriebsbedingungen, einschließlich mindestens einer Feinsuche (529), einer Berechnung (539) und einer Zugriffsoperation (549), durch ein Betreiben der Anschlüsse der Bitleitungsschaltung des zweiten Abschnitts (222, 322, 422, 622) der Speicherstränge gemäß den jeweiligen dynamischen Werten erzeugt worden sind.

2. Speichersystem (100, 800) nach Anspruch 1, welches ferner eine Zählschaltung (225) aufweist, die mit der Leseverstärkerschaltung (224) verbunden ist und die dazu ausgelegt ist, exakte Übereinstimmungen zwischen Werten, die in dem zweiten Abschnitt (222) der Speicherstränge gespeichert worden sind, und den jeweiligen dynamischen Werten zu zählen.

3. Speichersystem (100, 800) nach Anspruch 1 oder 2, welches ferner eine Summierschaltung (325) aufweist, die mit der Leseverstärkerschaltung (324) verbunden ist und die dazu ausgelegt ist, entsprechend den Strömen des zweiten Abschnitts (322) der Speicherstränge zu summieren, wobei die jeweiligen dynamischen Werte analoge Werte sind, die Werte in dem zweiten Abschnitt (222, 322, 422, 622) der Speicherstränge analoge Werte sind, und die Summierschaltung gemäß einer analogen Technik betreibbar ist, wobei die Summierschaltung ferner dazu ausgelegt ist, die Ströme vor dem Summieren zu skalieren.

4. Speichersystem (100, 800) nach einem der Ansprüche 1 bis 3, welches ferner einen oder mehrere Prozessoren (110, 810) aufweist, die dazu ausgelegt sind, auf die Speicheranordnung (250, 350, 450) zuzugreifen, oder welches einen oder mehrere Prozessoren (110, 810) aufweist, die dazu ausgelegt sind, auf ein rechnergestütztes Solid-State-Laufwerk (SSD) zuzugreifen, das die Speicheranordnung (250, 350, 450) aufweist, die mindestens eine Speichervorrichtung aufweist.

5. Speichersystem (100, 800) nach einem der Ansprüche 1 bis 4, wobei die Anschlüsse der Bitleitungsschaltung (211, 221, 311, 321, 411, 421), die mit den Bitleitungsanschlüssen des zweiten Abschnitts (222, 322, 422, 622) der Speicherstränge verbunden sind, ferner dazu ausgelegt sind, die gleichen vorbestimmten Betriebsbedingungen für die Bitleitungsanschlüsse des zweiten Abschnitts (222, 322, 422, 622) der Speicherstränge bereitzustellen, und die ferner eine Seiten-Cache-Schaltung aufweist, die mit der Leseverstärkerschaltung (214, 224, 314, 324, 414, 424) verbunden ist und die eine Seite von Ergebnissen zwischenspeichern kann, die aus Werten gelesen wurden, die in dem zweiten Abschnitt (222, 322, 422, 622) der Speicherstränge gespeichert worden sind.

6. Speichersystem (100, 800) nach einem der Ansprüche 1 bis 5, wobei die Bitleitungsschaltung (211, 221, 311, 321, 411, 421) dazu ausgelegt ist, denselben vorbestimmten Betriebszustand für die Bitleitungsanschlüsse bereitzustellen, wobei der bereitgestellte Wert einen Schlüssel und eine Maske aufweist, und ein selektives Ansteuern der Steuereingänge ein selektives Ansteuern der Steuereingänge in jeweiligen Paaren gemäß einer Vielzahl an Codierungen umfasst, die jeweils aus einem jeweiligen Bit des Schlüssels und einem entsprechenden jeweiligen Bit der Maske bestimmt worden sind, und wobei (i) eine erste der Codierungen ein selektives Abgleichen eines gespeicherten Nullwerts in Reaktion darauf ermöglicht, dass der bereitgestellte Wert Null ist, (ii) eine zweite der Codierungen ein selektives Abgleichen eines gespeicherten Einswerts in Reaktion darauf ermöglicht, dass der bereitgestellte Wert Eins ist, (iii) eine dritte der Codierungen ein selektives Abgleichen eines gespeicherten Nullwerts oder eines gespeicherten Einwerts in Reaktion darauf ermöglicht, dass der bereitgestellte Wert Null oder Eins ist, und (iv) eine vierte der Codierungen ein selektives Abgleichen eines gespeicherten Werts mit dem bereitgestellten Wert verhindert.

7. Verfahren zum Betreiben eines Speichersystems (100, 800) nach einem der Ansprüche 1 bis 6, wobei das Verfahren umfasst:
ein erstens Erfassen eines ersten Abschnitts (212, 312, 412, 612) an Speichersträngen einer Speicheranordnung (250, 350, 450) gemäß (i) ersten Spannungen, die auf Wortleitungen (WL1, WL2, ... WL48) der Speicheranordnung (250, 350, 450) anliegen und (ii) vorbestimmten Betriebsbedingungen des ersten Abschnitts (212, 312, 412, 612) der Speicherstränge,
ein zweites Erfassen eines zweiten Abschnitts (222, 322, 422, 622) der Speicherstränge der Speicheranordnung (250, 350, 450) gemäß (i) zweiten Spannungen, die auf Wortleitungen (WL1, WL2,... WL48) der Speicheranordnung (250, 350, 450) anliegen und (ii) dynamischen Betriebsbedingungen des zweiten Abschnitts (222, 322, 422, 622) der Speicherstränge, und
ein Bereitstellen von Ergebnissen der zweiten Erfassung,
wobei die zweiten Spannungen auf Ergebnissen der ersten Erfassung basieren,
wobei die dynamischen Betriebsbedingungen durch ein Betreiben von Bitleitungsschaltungsanschlüssen des zweiten Abschnitts (222, 322, 422, 622) der Speicherstränge gemäß einem dynamischen Wert erzeugt werden,
wobei die dynamischen Betriebsbedingungen aus mindestens einem von einer Feinsuche (529), einer Berechnung (539) und einem Zugriffsvorgang (549) ausgewählt worden sind.

8. Verfahren nach Anspruch 7, wobei das zweite Erfassen ein Zählen von ungefähren Übereinstimmungen zwischen Werten, die in dem zweiten Abschnitt (222, 322, 422, 622) der Speicherstränge gespeichert worden sind, und dem dynamischen Wert umfasst.

9. Verfahren nach Anspruch 7 oder 8, wobei das zweite Erfassen ein Summieren gemäß Strömen des zweiten Abschnitts (222, 322, 422, 622) der Speichersträngen umfasst, der dynamische Wert ein analoger Wert ist, Werte, die in dem zweiten Abschnitt (222, 322, 422, 622) der Speicherstränge gespeichert worden sind, analoge Werte sind, und das Summieren gemäß einer analogen Technik erfolgt, wobei das zweite Erfassen ein Skalieren und ein anschließendes Summieren der Ströme des zweiten Abschnitts (222, 322, 422, 622) der Speicherstränge umfasst.

10. Verfahren nach Anspruch 7, wobei die dynamischen Betriebsbedingungen auf einem dynamischen Wert und einem Maskenwert basieren, um eine Übereinstimmung des dynamischen Werts mit einem beliebigen Wert zu ermöglichen, der in einem beliebigen zweiten Abschnitt (222, 322, 422, 622) von Speicherstränge gespeichert worden ist.

11. Verfahren nach Anspruch 7, wobei die dynamischen Betriebsbedingungen auf einem dynamischen Wert und einem Maskenwert basieren, um die Übereinstimmung des dynamischen Werts mit einem beliebigen Wert, der in einem beliebigen zweiten Abschnitt (222, 322, 422, 622) der Speicherketten gespeichert worden ist, zu deaktivieren.

12. Verfahren nach einem der Ansprüche 7 bis 11, wobei die Ergebnisse der zweiten Erfassung eine Multiplikations-Akkumulations-Operation anzeigen, ein erster Operand der Multiplikations-Akkumulations-Operation ein dynamischer Wert ist, gemäß dem die dynamischen Betriebsbedingungen bestimmt werden, und ein zweiter Operand der Multiplikations-Akkumulations-Operation Werten entspricht, die in den zweiten Abschnitt (222, 322, 422, 622) der Speicherstränge programmiert worden sind.

13. Verfahren nach einem der Ansprüche 7 bis 11, wobei die dynamischen Betriebsbedingungen gemäß einem dynamischen Wert bestimmt werden und die Ergebnisse der zweiten Erfassung eine Suchoperation nach dem dynamischen Wert unter den Werten anzeigen, die in den zweiten Abschnitt (222, 322, 422, 622) der Speicherstränge programmiert worden sind.

## Revendications

1. Système de mémoire (100, 800) comprenant :
un réseau de mémoire (250, 350, 450) comprenant une première partie (212, 312, 412, 612) de chaînes de mémoire et une deuxième partie (222, 322, 422, 622) de chaînes de mémoire, une ou plusieurs des chaînes de mémoire de la première partie (212, 312, 412, 612) de chaînes de mémoire et une ou plusieurs des chaînes de mémoire de la deuxième partie (222, 322, 422, 622) de chaînes de mémoire comprenant des pluralités respectives de dispositifs de mémoire connectés en série ;
un circuit de ligne de mot (252, 352, 452) ayant des bornes couplées à des entrées de commande respectives de rangées respectives selon lesquelles les chaînes de mémoire sont organisées ;
un circuit de ligne de bit (211, 221, 311, 321, 411, 421) ayant des bornes couplées à des bornes respectives de ligne de bit des chaînes de mémoire ; et
un circuit d'amplification de détection (214, 224, 314, 324, 414, 424) ayant des bornes couplées à des bornes des chaînes de mémoire ;
dans lequel le circuit de ligne de mot (252, 352, 452) est activé pour piloter sélectivement les entrées de commande en fonction d'un élément parmi des premières et des deuxièmes valeurs de commande de ligne de mot, les premières valeurs de commande de ligne de mot correspondant à une valeur fournie et les deuxièmes valeurs de commande de ligne de mot correspondant à des résultats produits par le circuit d'amplification de détection (214, 224, 314, 324, 414, 424) sur la base d'informations fournies par l'intermédiaire des bornes couplées aux bornes de ligne de bit de la première partie (212, 312, 412, 612) de chaînes de mémoire,
dans lequel les bornes du circuit de ligne de bit (211, 221, 311, 321, 411, 421) couplées aux bornes de ligne de bit de la première partie (212, 312, 412, 612) de chaînes de mémoire sont activées pour fournir une condition de fonctionnement prédéterminée à la première partie (212, 312, 412, 612) de chaînes de mémoire ;
**caractérisé en ce que**
les bornes du circuit de ligne de bit (211, 221, 311, 321, 411, 421) couplées aux bornes de ligne de bit de la deuxième partie (222, 322, 422, 622) de chaînes de mémoire sont activées pour fournir des valeurs dynamiques respectives à la deuxième partie (222, 322, 422, 622) de chaînes de mémoire,
dans lequel des conditions de fonctionnement dynamiques comprenant au moins un élément parmi une recherche fine (529), un traitement informatique (539) et une opération d'accès (549), sont produites en faisant fonctionner des bornes du circuit de ligne de bit de la deuxième partie (222, 322, 422, 622) de chaînes de mémoire en fonction des valeurs dynamiques respectives.

2. Système de mémoire (100, 800) selon la revendication 1, comprenant en outre un circuit de comptage (225) couplé au circuit d'amplification de détection (224) et activé pour compter des correspondances exactes entre des valeurs stockées dans la deuxième partie (222) de chaînes de mémoire et les valeurs dynamiques respectives.

3. Système de mémoire (100, 800) selon la revendication 1 ou 2, comprenant en outre un circuit de sommation (325) couplé au circuit d'amplification de détection (324) et activé pour effectuer une sommation en fonction de courants de la deuxième partie (322) de chaînes de mémoire, dans lequel les valeurs dynamiques respectives sont des valeurs analogiques, les valeurs stockées dans la deuxième partie (222, 322, 422, 622) de chaînes de mémoire sont des valeurs analogiques, et le circuit de sommation est apte à fonctionner selon une technique analogique, l'ensemble de circuits de sommation étant en outre apte à normaliser les courants avant d'effectuer la sommation.

4. Système de mémoire (100, 800) selon l'une quelconque des revendications 1 à 3, comprenant en outre un ou plusieurs processeurs (110, 810) activé pour accéder au réseau de mémoire (250, 350, 450), ou comprenant un ou plusieurs processeurs (110, 810) activé pour accéder à un disque statique à semiconducteurs (SSD) computationnel comprenant le réseau de mémoire (250, 350, 450) comprenant au moins un dispositif de mémoire.

5. Système de mémoire (100, 800) selon l'une quelconque des revendications 1 à 4, dans lequel les bornes du circuit de ligne de bit (211, 221, 311, 321, 411, 421) couplées aux bornes de ligne de bit de la deuxième partie (222, 322, 422, 622) de chaînes de mémoire sont en outre activé pour fournir la même condition de fonctionnement prédéterminée aux bornes de ligne de bit de la deuxième partie (222, 322, 422, 622) de chaînes de mémoire et comprenant en outre un circuit de cache de page couplé au circuit d'amplification de détection (214, 224, 314, 324, 414, 424) et activé pour mettre en cache une page de résultats lue à partir de valeurs stockées dans la deuxième partie (222, 322, 422, 622) de chaînes de mémoire.

6. Système de mémoire (100, 800) selon l'une quelconque des revendications 1 à 5, dans lequel le circuit de ligne de bit (211, 221, 311, 321, 411, 421) est activé pour fournir une même condition de fonctionnement prédéterminée aux bornes de ligne de bit, la valeur fournie comprend une clé et un masque, et le pilotage sélectif des entrées de commande comprend le pilotage sélectif des entrées de commande par paires respectives selon une pluralité de codages déterminés respectivement à partir d'un bit respectif de la clé et d'un bit respectif correspondant du masque, et (i) un premier des codages permet de faire correspondre sélectivement une valeur zéro stockée en réponse à la valeur fournie qui est zéro, (ii) un deuxième des codages permet de faire correspondre sélectivement une valeur un stockée en réponse à la valeur fournie qui est un, (iii) un troisième des codages permet de faire correspondre sélectivement une valeur zéro stockée ou une valeur un stockée en réponse à la valeur fournie qui est zéro ou un, et (iv) un quatrième des codages désactive la mise en correspondance sélective de toute valeur stockée avec la valeur fournie.

7. Procédé pour faire fonctionner un système de mémoire (100, 800) selon l'une quelconque des revendications 1 à 6, le procédé comprenant :
une première détection d'une première partie (212, 312, 412, 612) de chaînes de mémoire d'un réseau de mémoire (250, 350, 450) en fonction de (i) premières tensions appliquées sur des lignes de mot (WL1, WL2,... WL48) du réseau de mémoire (250, 350, 450), et (ii) de conditions de fonctionnement prédéterminées de la première partie (212, 312, 412, 612) de chaînes de mémoire ;
une deuxième détection d'une deuxième partie (222, 322, 422, 622) de chaînes de mémoire du réseau de mémoire (250, 350, 450) en fonction de (i) deuxièmes tensions appliquées sur des lignes de mot (WL1, WL2,... WL48) du réseau de mémoire (250, 350, 450), et (ii) de conditions de fonctionnement dynamiques de la deuxième partie (222, 322, 422, 622) de chaînes de mémoire ; et
la fourniture de résultats de la deuxième détection,
dans lequel les deuxièmes tensions sont basées sur des résultats de la première détection ;
dans lequel les conditions de fonctionnement dynamiques sont produites en faisant fonctionner des bornes du circuit de ligne de bit de la deuxième partie (222, 322, 422, 622) de chaînes de mémoire en fonction d'une valeur dynamique,
dans lequel les conditions de fonctionnement dynamiques sont sélectionnées parmi au moins une recherche fine (529), un traitement informatique (539) et une opération d'accès (549).

8. Procédé selon la revendication 7, dans lequel la deuxième détection comprend le comptage de correspondances approximatives entre des valeurs stockées dans la deuxième partie (222, 322, 422, 622) de chaînes de mémoire et la valeur dynamique.

9. Procédé selon la revendication 7 ou 8, dans lequel la deuxième détection comprend la sommation en fonction de courants de la deuxième partie (222, 322, 422, 622) de chaînes de mémoire, la valeur dynamique est une valeur analogique, les valeurs stockées dans la deuxième partie (222, 322, 422, 622) de chaînes de mémoire sont des valeurs analogiques, et la sommation se fait selon une technique analogique, la deuxième détection comprend la normalisation puis la sommation des courants de la deuxième partie (222, 322, 422, 622) de chaînes de mémoire.

10. Procédé selon la revendication 7, dans lequel les conditions de fonctionnement dynamiques sont basées sur une valeur dynamique et une valeur de masque pour permettre la mise en correspondance de la valeur dynamique avec toute valeur stockée dans la deuxième partie (222, 322, 422, 622) de chaînes de mémoire.

11. Procédé selon la revendication 7, dans lequel les conditions de fonctionnement dynamiques sont basées sur une valeur dynamique et une valeur de masque pour désactiver la mise en correspondance de la valeur dynamique avec toute valeur stockée dans la deuxième partie (222, 322, 422, 622) de chaînes de mémoire.

12. Procédé selon l'une quelconque des revendications 7 à 11, dans lequel les résultats de la deuxième détection sont indicatifs d'une opération de multiplication-accumulation, un premier opérande de l'opération de multiplication-accumulation est une valeur dynamique selon laquelle les conditions de fonctionnement dynamiques sont déterminées, et un deuxième opérande de l'opération de multiplication-accumulation correspond à des valeurs programmées dans la deuxième partie (222, 322, 422, 622) de chaînes de mémoire.

13. Procédé selon l'une quelconque des revendications 7 à 11, dans lequel les conditions de fonctionnement dynamiques sont déterminées en fonction d'une valeur dynamique et les résultats de la deuxième détection sont indicatifs d'une opération de recherche de la valeur dynamique parmi des valeurs programmées dans la deuxième partie (222, 322, 422, 622) de chaînes de mémoire.
